# EUROPEAN PATENT APPLICATION

(11) **EP 4 492 144 A1**
(43) Date of publication of application: **15.01.2025**
(21) Application number: 24185618.6
(22) Date of filing: 01.07.2024
(51) Int. Cl.: G03F 7/09

(54) **COMPOSITION FOR FORMING RESIST UNDERLAYER FILM, PATTERNING PROCESS, AND METHOD FOR FORMING RESIST UNDERLAYER FILM**

(30) Priority: 07.07.2023 JP 2023112290
(71) Applicant: Shin-Etsu Chemical Co., Ltd., Chiyoda-ku, Tokyo 1000005 (JP)
(72) Inventor: Ishiwata, Kenta, Niigata (JP); Kori, Daisuke, Niigata (JP); Yano, Toshiharu, Niigata (JP); Kobayashi, Naoki, Niigata (JP); Niida, Keisuke, Niigata (JP)
(74) Representative: Sonnenhauser, Thomas Martin

(57) **Abstract**

The present invention is a composition for forming a resist underlayer film, containing: (A) a polymer having a structure represented by the following general formula (1) as a repeating unit; and (B) an organic solvent, where the polymer (A) has a molecular weight of 300 to 3,000, and the polymer (A) contains neither a repeating unit containing a hydroxy group as a substituent nor a repeating unit containing a heteroaromatic ring, and where Ar represents an unsubstituted divalent aromatic group having 6 to 30 carbon atoms. This can provide a composition for forming a resist underlayer film with which it is possible to form a resist underlayer film that exhibits much better dry etching resistance than those of conventional organic underlayer film materials.

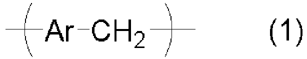

## Description

### TECHNICAL FIELD

The present invention relates to: a composition for forming a resist underlayer film; a patterning process; and a method for forming a resist underlayer film. More specifically, the present invention relates to: a composition for forming a resist underlayer film usable for fine patterning according to a multilayer resist method in a semiconductor device manufacturing process; a patterning process using the composition; and a method for forming a resist underlayer film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a material used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in, for example, Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type material for an organic underlayer film excellent in filling and planarizing properties, for example, the composition disclosed in Patent Document 2 has been reported. However, in view of application of this composition in the advanced generation, there is a concern about dry etching resistance. The application limit of the previously-known coating-type composition for an organic underlayer film is thus approaching.

To solve the above problems, Patent Document 3 reports that etching resistance at the time of substrate processing can be improved by heating the resist underlayer film under an atmosphere having an oxygen concentration of less than 1 vol% at a temperature of 450°C or higher and 800°C or lower. However, many of the resist underlayer films used in the Examples contain a resin or a compound containing hydroxy groups or propargyl groups, and are thought to be unfavorable from the viewpoint of etching resistance, since oxygen atoms remain in the films.

Patent Document 4 reports a resist underlayer film material containing a condensed polynuclear aromatic (COPNA) resin. There are discussions regarding flatness of a cured film on being treated at 400°C, but there are no examples where baking is performed in an inert gas at more than 500°C to form a cured film, and change in the etching resistance of a cured film formed by a treatment under inert gas under high temperature conditions has not been clarified.

### CITATION LIST

### PATENT LITERATURE

Patent Document 1: JP2004-205685A
Patent Document 2: JP2017-119671A
Patent Document 3: JP2016-206676A
Patent Document 4: JP2017-092457A

### SUMMARY OF INVENTION

### TECHNICAL PROBLEM

The present invention has been made in view of the above-described circumstances. An object of the present invention is to provide: a composition for forming a resist underlayer film with which it is possible to form a resist underlayer film that exhibits much better dry etching resistance than those of conventional organic underlayer film materials; a patterning process in which the composition is used as a resist underlayer film material; and a method for forming a resist underlayer film, using the composition.

### SOLUTION TO PROBLEM

To achieve the object, the present invention provides a composition for forming a resist underlayer film, comprising:
(A) a polymer having a structure represented by the following general formula (1) as a repeating unit; and
(B) an organic solvent,
   wherein the polymer (A) has a molecular weight of 300 to 3,000, and the polymer (A) contains neither a repeating unit containing a hydroxy group as a substituent nor a repeating unit containing a heteroaromatic ring, 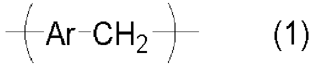 wherein Ar represents an unsubstituted divalent aromatic group having 6 to 30 carbon atoms.

Such a composition for forming a resist underlayer film, containing the polymer (A) having the structure represented by the general formula (1), does not contain, as the polymer (A), a polymer constituted by a repeating unit having a hydroxy group and/or a heteroaromatic ring, and therefore, it is possible to form, for example, by thermosetting, a resist underlayer film (high-carbon film) excellent in dry etching resistance at the time of substrate processing.

In addition, since the molecular weight is in the above-described range, not only is solvent solubility excellent, excellent thermal decomposition is exhibited by high-temperature treatment. In the inventive composition for forming a resist underlayer film, dissociation and recombination of carbon bonds of the polymer (A) are promoted by thermal decomposition, and the composition is provided with a diamond-like carbon structure. Thus, it is possible to form a resist underlayer film that is high-carbon and is excellent in etching resistance.

The aromatic group Ar preferably has any of the following structures (1-a), 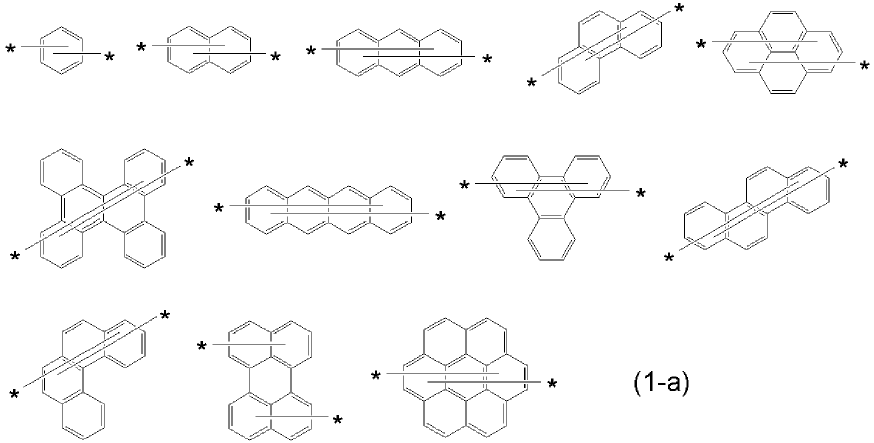 wherein "*" represents an attachment point to the methylene group (CH₂) in the general formula (1).

When the aromatic group Ar has any of the structures (1-a), dissociation and recombination of carbon bonds are promoted during high-temperature treatment by methylene, which is easily thermally decomposed, being contained in addition to an aromatic ring having a high carbon density, and it is possible to form a resist underlayer film having a diamond-like carbon structure.

The aromatic group Ar preferably represents any of naphthalene, anthracene, phenanthrene, and pyrene.

The aromatic group Ar preferably represents any of naphthalene, anthracene, phenanthrene, and pyrene from the viewpoints of solvent solubility and productivity.

The polymer (A) is preferably a copolymer having two kinds of repeating units represented by the following general formulae (2), 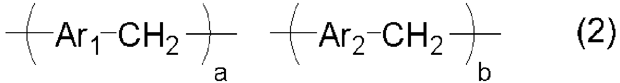 wherein Ar₁ represents any of naphthalene, anthracene, phenanthrene, and pyrene; Ar₂ has a structure different from that of Ar₁ and has any structure selected from the following formulae (1-a); and a+b is 100, 30 ≤ a ≤ 99, and 1 ≤ b ≤ 70.

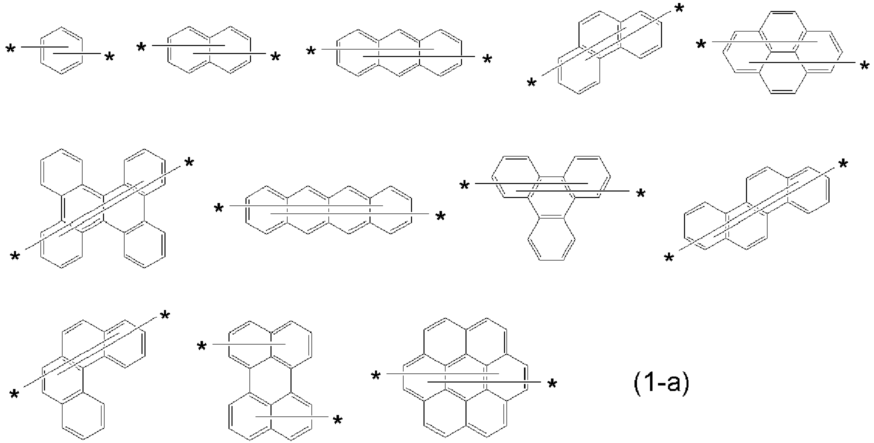

When the composition for forming a resist underlayer film contains a polymer (A) having structures represented by the general formulae (2), solvent solubility can be enhanced while maintaining a high-carbon composition.

In this case, the polymer (A), being the copolymer having two kinds of repeating units represented by the general formulae (2), is more preferably a polymerization reaction product of a monomer represented by the following formula (2-a) and a monomer represented by the following formula (2-b),

Ar₁-CH₂-X (2-a)

Ar₂-CH₂-X (2-b)

wherein Ar₁ represents any of naphthalene, anthracene, phenanthrene, and pyrene; Ar₂ has a structure different from that of Ar₁ and has any structure selected from the formulae (1-a); and X represents a hydroxy group, an alkoxy group having 1 to 4 carbon atoms, or a halogen group.

A polymer (A) obtained by a polymerization reaction between such monomers represented by the formulae (2-a) and (2-b) randomly contains different Ar structures, and therefore, when the polymer is contained in the composition for forming a resist underlayer film, it is possible to provide a composition for forming a resist underlayer film having better solvent solubility.

The Ar₁ in the formulae (2) is further preferably anthracene.

Such a composition for forming a resist underlayer film, where the Ar₁ in the formulae (2) is anthracene, is further advantageous from the viewpoint of productivity, in addition to the viewpoints of etching resistance and solvent solubility.

The polymer (A) preferably has a molecular weight of 300 to 1,500.

When the polymer (A) has a molecular weight of 300 to 1,500, it is possible to provide a composition for forming a resist underlayer film excellent in solvent solubility. In addition, when a resist underlayer film is formed using the composition, it is possible to provide a resist underlayer film excellent in film thickness uniformity.

The polymer (A) preferably has an end-capping group represented by the following general formula (3), 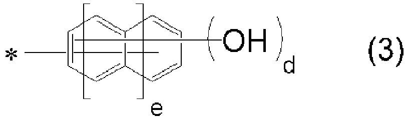 wherein "*" represents an attachment point to the methylene group in the formula (1); "d" represents an integer of 1 to 9; and "e" represents an integer of 0 to 2 .

A composition for forming a resist underlayer film containing such a polymer (A) having a structure represented by the general formula (3) can have enhanced adhesiveness to a substrate without dry etching resistance being degraded.

The composition for forming a resist underlayer film preferably further comprises (C) a blend resin, being a phenolic resin or a resin containing a phenolic hydroxy group.

Such a composition for forming a resist underlayer film containing a phenolic resin or a resin containing a phenolic hydroxy group makes it possible to enhance film thickness uniformity while minimizing the degradation of etching resistance after high-temperature treatment under a nitrogen atmosphere.

In this case, the blend resin (C) preferably has a molecular weight of 4,000 to 12,000.

When the composition for forming a resist underlayer film contains a blend resin (C) having a molecular weight within the above range, the composition can be provided with excellent film thickness uniformity after high-temperature treatment under a nitrogen atmosphere without degradation of filling property and/or planarizing property.

Furthermore, the blend resin (C) is preferably contained in an amount of 10 to 100 parts by mass based on 100 parts by mass of the polymer (A).

When the composition for forming a resist underlayer film contains the blend resin (C) in an amount of 10 to 100 parts by mass based on 100 parts by mass of the polymer (A), it is possible to achieve both high film thickness uniformity and high dry etching resistance after high-temperature treatment under a nitrogen atmosphere.

Furthermore, the blend resin (C) is preferably a resin represented by any of the following general formulae (C-1), (C-2), and (C-3), 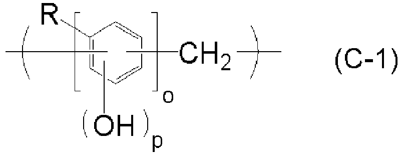 wherein R represents an organic group having a valency of 1 to 3, having 1 to 20 carbon atoms, and optionally containing an oxygen atom; "o" represents an integer of 1 to 3; and "p" represents an integer of 1 to 3, 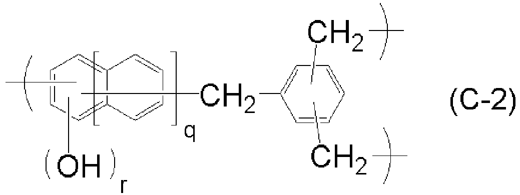 wherein "q" represents an integer of 0 or 1; and "r" represents an integer of 1 to 6, 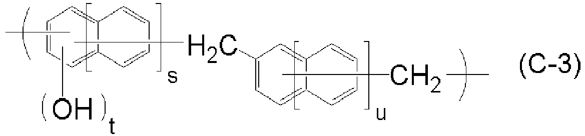 wherein "s" represents an integer of 0 or 1; "t" represents an integer of 1 to 6; and "u" represents an integer of 0 or 1.

When the blend resin (C) has a structure represented by any of the formulae (C-1) to (C-3), it is possible to achieve both higher film thickness uniformity and higher etching resistance after high-temperature treatment under a nitrogen atmosphere.

The composition for forming a resist underlayer film preferably further comprises (D) a crosslinking agent having a structure represented by the following general formula (4), 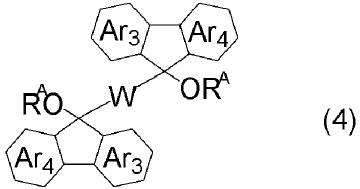 wherein Ar₃ and Ar₄ each represent a benzene ring or naphthalene ring optionally having a substituent; R^{A} represents a hydrogen atom or a monovalent organic group having 1 to 20 carbon atoms; W represents a group represented by any of the following general formulae (5), 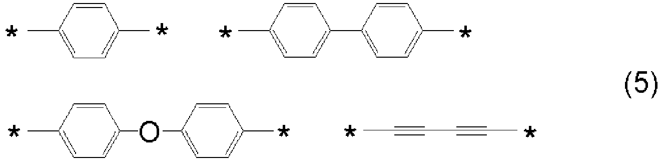 wherein "*" represents an attachment point.

When the composition for forming a resist underlayer film contains such a crosslinking agent having a structure represented by the general formula (4), it is possible to provide a composition for forming a resist underlayer film having a higher crosslinking density. As a result, it is possible to provide a composition for forming a resist underlayer film having stronger etching resistance. Furthermore, by performing crosslinking before high-temperature treatment under a nitrogen atmosphere, it is possible to improve film thickness uniformity at the time of high-temperature treatment.

The composition for forming a resist underlayer film preferably further comprises (E) a flowability accelerator having a weight reduction rate of less than 30% on heating from 30°C to 190°C and having a weight reduction rate of 98% or more on heating from 30°C to 350°C.

The flowability accelerator (E) contributes to enhancement in the flowability of the composition at the time of application and is eliminated from the film after baking at 350°C, and therefore, it is possible to enhance filling property and/or flatness without degrading etching resistance. In addition, it is also possible to suppress the generation of defects induced by dryness, and the flowability accelerator can also contribute to enhancement in yield in semiconductor production.

In this case, the flowability accelerator (E) preferably contains one or more compounds selected from the group consisting of compounds represented by the following general formulae (i) to (iii), 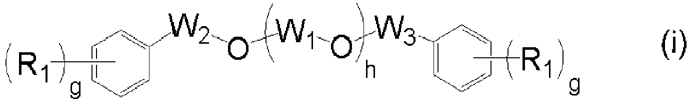 wherein each R₁ independently represents a hydrogen atom, a hydroxy group, or an organic group having 1 to 10 carbon atoms and optionally being substituted; W₁ represents a phenylene group or a divalent group represented by the following general formula (i-1); W₂ and W₃ each represent a single bond or a divalent group represented by either of the following general formulae (i-2); "g" represents an integer of 1 to 5; and "h" represents an integer of 0 to 10, 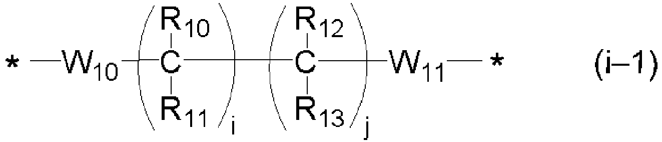 wherein "*" represents an attachment point; R₁₀, R₁₁, R₁₂, and R₁₃ each represent a hydrogen atom, a hydroxy group, or an organic group having 1 to 10 carbon atoms; W₁₀ and W₁₁ each independently represent a single bond or a carbonyl group; and "i" and "j" each represent an integer of 0 to 10, provided that i + j ≥ 1, 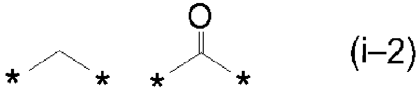 wherein "*" represents an attachment point, 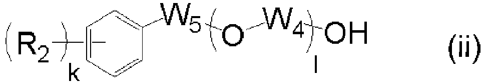 wherein each R₂ independently represents a hydrogen atom or an organic group having 1 to 10 carbon atoms and optionally being substituted; W₄ represents a divalent group represented by the following general formula (ii-1); W₅ represents a single bond or a divalent group represented by either of the following general formulae (ii-2); "k" represents an integer of 0 to 5; and "l" represents an integer of 2 to 10, 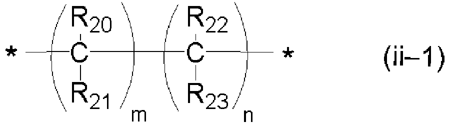 wherein "*" represents an attachment point; R₂₀, R₂₁, R₂₂, and R₂₃ each represent a hydrogen atom, a hydroxy group, or an organic group having 1 to 10 carbon atoms; and "m" and "n" each represent an integer of 0 to 10, provided that m + n ≥ 1, 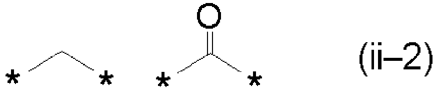 wherein "*" represents an attachment point, 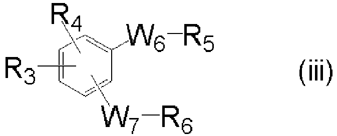 wherein R₃ and R₄ each represent a hydrogen atom, a hydroxy group, or an organic group having 1 to 10 carbon atoms, optionally being substituted, and optionally being bonded to each other to form a cyclic structure; R₅ and R₆ each represent an organic group having 1 to 10 carbon atoms, R₅ being a group containing either an aromatic ring or a divalent group represented by the following general formula (iii-1); and W₆ and W₇ each represent a single bond or a divalent group represented by either of the following general formulae (iii-2), at least one of W₆ and W₇ being a divalent group represented by either of the general formulae (iii-2), 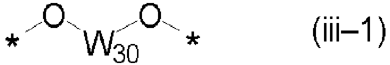 wherein "*" represents an attachment point; and W₃₀ represents an organic group having 1 to 4 carbon atoms, 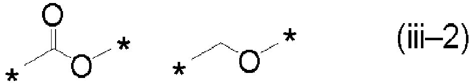 wherein "*" represents an attachment point.

When thermal flowability is imparted to the polymer (A) by the addition of the flowability accelerator (E) containing one or more compounds selected from the general formulae (i) to (iii), the composition for forming a resist underlayer film also has high filling property and/or flatness.

The composition for forming a resist underlayer film preferably further comprises one or more of:
(F) a surfactant;
(G) an acid generator; and
(H) a plasticizer.

When the composition for forming a resist underlayer film contains one or more of the additives, the composition for forming a resist underlayer film has better coating property, etching resistance, filling property, and/or flatness.

The present invention also provides a patterning process for forming a pattern in a substrate to be processed, comprising the steps of:
(I-1) applying the inventive composition for forming a resist underlayer film onto a substrate to be processed to obtain a coating film, then heating the coating film to form a resist underlayer film;
(I-2) forming a resist upper layer film on the resist underlayer film by using a photoresist material;
(I-3) subjecting the resist upper layer film to pattern exposure and then to development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The patterning process according to a two-layer resist process makes it possible to form a fine pattern in a body to be processed (substrate to be processed).

The present invention also provides a patterning process for forming a pattern in a substrate to be processed, comprising the steps of:
(II-1) applying the inventive composition for forming a resist underlayer film onto a substrate to be processed to obtain a coating film, then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then to development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

The patterning process according to a three-layer resist process makes it possible to form a fine pattern in a body to be processed with high accuracy.

The present invention also provides a patterning process for forming a pattern in a substrate to be processed, comprising the steps of:
(III-1) applying the inventive composition for forming a resist underlayer film onto a substrate to be processed to obtain a coating film, then heating the coating film to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

The patterning process according to a four-layer resist process makes it possible to form a fine pattern in a body to be processed with high accuracy.

A substrate having a structure or step having a height of 30 nm or more can be used as the substrate to be processed.

The inventive patterning processes use the resist underlayer film composition of the present invention, which makes it possible to form a resist underlayer film having high filling property and/or flatness, and therefore, the inventive patterning processes are particularly useful for fine processing of a substrate having such a structure or step.

The present invention also provides a method for forming a resist underlayer film that serves as an organic flat film used in a semiconductor device manufacturing process, the method comprising:
applying the inventive composition for forming a resist underlayer film onto a substrate to be processed by spin-coating to obtain a coating film; and
heating the coating film at a temperature of 450°C or higher and 800°C or lower for 10 to 600 seconds to cure the coating film and form a resist underlayer film.

According to such a method, the crosslinking reaction during the formation of the resist underlayer film can be promoted, so that mixing with a resist upper layer film can be more highly suppressed. In addition, by appropriately adjusting the heating temperature and time, and oxygen concentration within the above-described ranges, thermal decomposition is promoted, so that it is possible to form a film excellent in dry etching resistance.

The present invention also provides a method for forming a resist underlayer film that serves as an organic flat film used in a semiconductor device manufacturing process, the method comprising:
applying the inventive composition for forming a resist underlayer film onto a substrate to be processed by spin-coating to obtain a coating film; and
heating the coating film under an atmosphere with an oxygen concentration of 1% or more and 21% or less to cure the coating film and form a resist underlayer film.

According to such a method, the crosslinking reaction during the formation of the resist underlayer film can be promoted, so that mixing with a resist upper layer film can be more highly suppressed. In addition, by appropriately adjusting the heating temperature and time, and oxygen concentration within the above-described ranges, thermal decomposition is promoted, so that it is possible to form a film excellent in dry etching resistance.

The present invention also provides a method for forming a resist underlayer film that serves as an organic flat film used in a semiconductor device manufacturing process, the method comprising:
applying the inventive composition for forming a resist underlayer film onto a substrate to be processed by spin-coating to obtain a coating film; and
heating the coating film under an atmosphere with an oxygen concentration of less than 1% to cure the coating film and form a resist underlayer film.

According to such a method, the crosslinking reaction during the resist underlayer film formation can be promoted without causing the degradation of the substrate to be processed even when the substrate to be processed includes a material that is unstable to heating under an oxygen atmosphere, and thus, a film excellent in dry etching resistance can be formed.

In this event, a substrate having a structure or step having a height of 30 nm or more can be used as the substrate to be processed.

The inventive methods for forming a resist underlayer film use the resist underlayer film material of the present invention, which makes it possible to form a resist underlayer film having high filling property and/or flatness while having high dry etching resistance, and therefore, the inventive methods are particularly suitable for forming a resist underlayer film on a substrate having such a structure or step.

### ADVANTAGEOUS EFFECTS OF INVENTION

As described above, the inventive composition for forming a resist underlayer film can form a resist underlayer film (high-carbon film) excellent in dry etching resistance at the time of substrate processing.

In addition, according to the inventive patterning processes, a fine pattern can be formed in a body to be processed with high precision.

Furthermore, according to the inventive methods for forming a resist underlayer film, it is possible to form a film excellent in dry etching resistance.

Furthermore, the inventive composition for forming a resist underlayer film, patterning processes, and methods for forming a resist underlayer film are suitably used particularly in a multilayer resist process, including filling and/or planarization of a substrate to be processed having steps and irregularities, and are significantly useful in fine patterning for the manufacture of semiconductor devices. In particular, in a fine patterning process using a multilayer resist method in a semiconductor device manufacturing process, even on a substrate to be processed having a portion where filling and/or planarization are difficult to be performed, such as a portion with a dense fine pattern structure portion with a high aspect ratio typified by a DRAM under progressing miniaturization, filling can be performed without causing defects such as voids and peeling. Therefore, a resist underlayer film having excellent planarizing property can be formed. Furthermore, the present inventions exhibit better etching resistance than that of conventional resist underlayer films, without the degradation of the in-plane uniformity of film thickness, and, in particularly, the effect can be exhibited by heating in an atmosphere having an oxygen concentration of less than 1 vol% at a temperature of 450°C or higher and 800°C or lower. Accordingly, it is possible to form a fine pattern in a body to be processed with even higher accuracy.

### BRIEF DESCRIPTION OF DRAWINGS

FIG. 1 is an explanatory view of an example (three-layer resist process) of the patterning process of the present invention.
FIG. 2 is an explanatory view of a method for evaluating filling property.
FIG. 3 is an explanatory view of a method for evaluating planarizing property.

### DESCRIPTION OF EMBODIMENTS

As stated above, there have been demands for the development of a composition for forming a resist underlayer film used for forming a resist underlayer film that makes it possible to transfer a resist pattern to a substrate to be processed with higher accuracy in a fine patterning process using a multilayer resist method.

The present inventors have focused on a method for enhancing the dry etching resistance of a resist underlayer film at the time of substrate processing by heating, for example, in an atmosphere having an oxygen concentration of less than 1 vol% at a temperature of 450°C or higher and 800°C or lower, embarked on the development of a composition for forming a resist underlayer film whose dry etching resistance is enhanced dramatically by the above-described method, and studied earnestly. The present inventors have found out that, unlike a resist underlayer film material excellent in heat resistance, a high-carbon material in which thermal decomposition of the cured film actively occurs due to high temperature baking undergoes dissociation and recombination of carbon bonds when the material is heated at a temperature of, for example, 450°C or higher and 800°C or lower, and thus, the cured film is densified. The present inventors have further studied earnestly and found out that a polymer having a structure represented by the general formula (1), constituted by only carbon and hydrogen, as a repeating unit and containing neither a repeating unit containing a hydroxy group as a substituent nor a repeating unit containing a heteroaromatic ring allows the resist underlayer film to be densified when heated, for example, in an atmosphere having an oxygen concentration of less than 1 vol% at a temperature of 450°C or higher and 800°C or lower, and exhibits much better dry etching resistance than that of conventional resist underlayer films. Based on these findings, the present invention has been completed.

That is, the present invention is a composition for forming a resist underlayer film, comprising:
(A) a polymer having a structure represented by the following general formula (1) as a repeating unit; and
(B) an organic solvent,
   wherein the polymer (A) has a molecular weight of 300 to 3,000, and the polymer (A) contains neither a repeating unit containing a hydroxy group as a substituent nor a repeating unit containing a heteroaromatic ring, 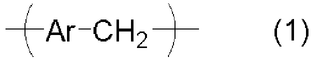 wherein Ar represents an unsubstituted divalent aromatic group having 6 to 30 carbon atoms.

Hereinafter, the present invention will be described in detail, but the present invention is not limited thereto.

### <Composition for Forming Resist Underlayer Film>

The inventive composition for forming a resist underlayer film contains: (A) a polymer having a structure represented by the following general formula (1) as a repeating unit; and (B) an organic solvent. The polymer (A) has a molecular weight of 300 to 3,000, and the polymer (A) contains neither a repeating unit containing a hydroxy group as a substituent nor a repeating unit containing a heteroaromatic ring.

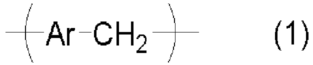

In the formula (1), Ar represents an unsubstituted divalent aromatic group having 6 to 30 carbon atoms.

The composition for forming a resist underlayer film containing the polymer (A) having the structure of the formula (1), constituted by only carbon and hydrogen, as a repeating unit and not containing a repeating unit containing a hydroxy group as a substituent or a repeating unit containing a heteroaromatic ring allows the resist underlayer film to be densified when baked at a high temperature under a nitrogen atmosphere, and makes it possible to form a resist underlayer film that exhibits excellent etching resistance.

The aromatic group Ar is preferably an unsubstituted divalent organic group having 6 to 30 carbon atoms, and more preferably has any of the following structures (1-a).

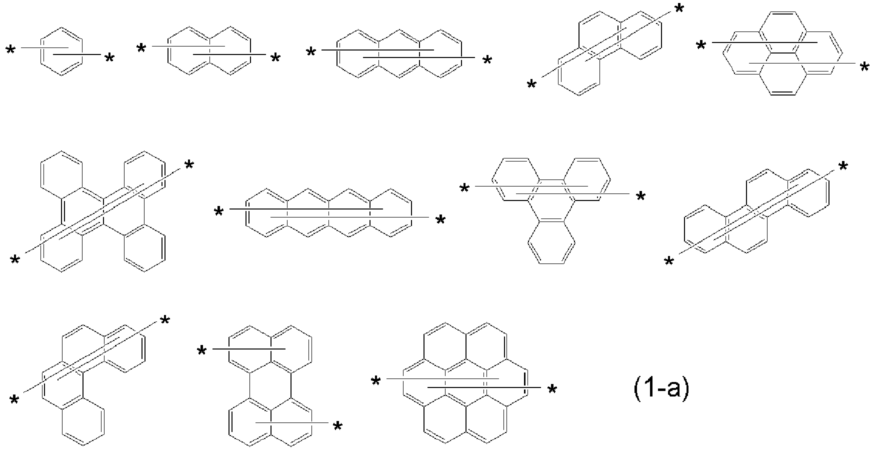

In the formulae (1-a), "*" represents an attachment point to the methylene group (CH₂) in the general formula (1) .

The aromatic group Ar more preferably has any of the structures (1-a), but from the viewpoints of etching resistance and solvent solubility, and furthermore, from the viewpoint of productivity, the aromatic group Ar is particularly preferably any of naphthalene, anthracene, phenanthrene, and pyrene. From the viewpoint that dissociation and recombination of carbon bonds during high-temperature treatment under a nitrogen atmosphere are facilitated so that an amorphous-carbon-like film can be formed, the aromatic group Ar is more preferably naphthalene or anthracene, further preferably anthracene.

The polymer (A) has a molecular weight of 300 to 3,000, preferably 300 to 2,000, and more preferably 300 to 1,500.

When the polymer (A) has a molecular weight of 300 to 3,000, a composition for forming a resist underlayer film excellent in solvent solubility can be achieved, and it is possible to form a resist underlayer film excellent in film thickness uniformity after baking at a high temperature under a nitrogen atmosphere. If the molecular weight is less than 300, the amount of sublimation product at the time of the high-temperature treatment is large, and therefore, film thickness uniformity is degraded. On the other hand, if the molecular weight is greater than 3,000, solvent solubility is degraded.

Furthermore, when the aromatic group Ar is benzene, the polymer (A) preferably has a molecular weight of 500 to 3000. When the aromatic group Ar is naphthalene, the polymer (A) preferably has a molecular weight of 500 to 2500. When the aromatic group Ar is anthracene, the polymer (A) preferably has a molecular weight of 400 to 800. When the aromatic group Ar is phenanthrene, the polymer (A) preferably has a molecular weight of 400 to 800. When the aromatic group Ar is pyrene, the polymer (A) preferably has a molecular weight of 400 to 800.

The polymer (A) is preferably a copolymer having two kinds of repeating units represented by the following general formulae (2).

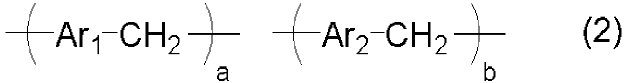

In the formulae (2), Ar₁ represents any of naphthalene, anthracene, phenanthrene, and pyrene; Ar₂ has a structure different from that of Ar₁ and has any structure selected from the formulae (1-a); and a+b is 100, 30 ≤ a ≤ 99, and 1 ≤ b ≤ 70.

In the formulae (2), Ar₁ represents any of naphthalene, anthracene, phenanthrene, and pyrene, but from the viewpoint that dissociation and recombination of carbon bonds during high-temperature treatment under a nitrogen atmosphere are easily facilitated so that an amorphous-carbon-like film can be formed, Ar₁ is preferably naphthalene or anthracene, further preferably anthracene. Furthermore, in the formulae (2), Ar₂ has a structure different from that of Ar₁, and when Ar₁ is anthracene, Ar₂ is preferably naphthalene, phenanthrene, or pyrene from the viewpoints of etching resistance, solvent solubility, and productivity.

In the formulae (2), the ranges of "a" and "b" are 30 ≤ a ≤ 99 and 1 ≤ b ≤ 70, and from the viewpoints of etching resistance and solvent solubility, preferably 50 ≤ a ≤ 80 and 20 ≤ b ≤ 50.

The polymer (A), being the copolymer having two kinds of repeating units represented by the general formulae (2), is preferably a polymerization reaction product of a monomer represented by the following formula (2-a) and a monomer represented by the following formula (2-b).

Ar₁-CH₂-X (2-a)

Ar₂-CH₂-X (2-b)

In the formulae, Ar₁ and Ar₂ are identical to those in the formulae (2); and X represents a hydroxy group, an alkoxy group having 1 to 4 carbon atoms, or a halogen group.

In the formula (2-a) and the formula (2-b), X represents a hydroxy group, an alkoxy group having 1 to 4 carbon atoms, or a halogen group, and from the viewpoints of productivity and reactivity, preferably a hydroxy group or a methoxy group, further preferably a hydroxy group. Note that, although the monomers respectively represented by the formula (2-a) and the formula (2-b) may contain a hydroxy group as X, X is eliminated by the polymerization reaction, and therefore, the polymer, being a polymerization reaction product of these monomers and having the structure represented by the formulae (2), does not contain a hydroxy group in the repeating units.

The polymer (A) preferably has an end-capping group represented by the following general formula (3).

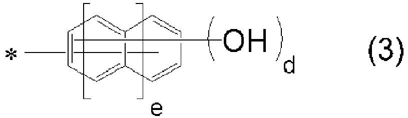

In the formula (3), "*" represents an attachment point to the methylene group (CH₂) in the formula (1) or the formulae (2); "d" represents an integer of 1 to 9; and "e" represents an integer of 0 to 2.

In the formula (3), "d" represents an integer of 1 to 9 and "e" represents an integer of 0 to 2, and from the viewpoints of balance between etching resistance and solvent solubility/substrate adhesiveness, and furthermore, the view of productivity, "d" is preferably 1 or 2 and "e" is preferably 0 or 1. When it is desired to enhance etching resistance, "d" is preferably small and "e" is preferably large, and when it is desired to enhance solvent solubility/substrate adhesiveness, "d" is preferably large and "e" is preferably small.

Note that, although the polymer (A) may contain the end-capping group represented by the formula (3) on an end, no hydroxy groups are contained in the repeating units constituting the polymer (A).

### [First Method for Manufacturing Polymer (A)]

The polymer (A), having the structure represented by the formula (1) as a repeating unit can be obtained, for example, by a polycondensation reaction, shown below, between an aromatic ring compound or condensed aromatic ring compound represented by Ar' and formaldehyde. In the following formulae, Ar is as defined above, and Ar' represents an aromatic ring compound or a condensed aromatic ring compound having an unsubstituted aromatic ring having 6 to 30 carbon atoms.

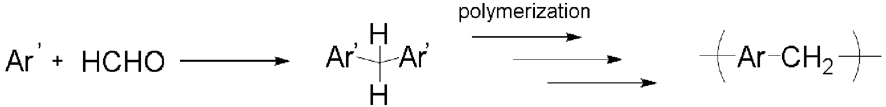

One kind of the aromatic ring compound or condensed aromatic ring compound used in the polycondensation reaction may be used, or two or more kinds thereof may be used, and the compounds can be appropriately selected and combined in accordance with required properties.

A polycondensation reaction can usually be achieved in an organic solvent in the presence of an acid catalyst at room temperature or, as necessary, under cooling or heating. Examples of acid catalysts that can be used include: inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; and Lewis acids, such as aluminum trichloride, aluminum ethoxide, aluminum isopropoxide, boron trifluoride, boron trichloride, boron tribromide, tin tetrachloride, tin tetrabromide, dibutyltin dichloride, dibutyltin dimethoxide, dibutyltin oxide, titanium tetrachloride, titanium tetrabromide, titanium (IV) methoxide, titanium (IV) ethoxide, titanium (IV) isopropoxide, and titanium (IV) oxide.

The synthesis may be carried out using any of the acid catalysts given above, but when the polymer is synthesized with a Lewis acid containing metal, it is difficult to remove the metal from the polymer. Therefore, an organic acid containing no metal is preferable, and trifluoroacetic acid, methanesulfonic acid, benzenesulfonic acid, and p-toluenesulfonic acid are further preferable.

Examples of the organic solvent used in the polycondensation reaction include: alcohols, such as methanol, ethanol, isopropyl alcohol, butanol, ethylene glycol, propylene glycol, diethylene glycol, glycerol, ethylene glycol monomethyl ether, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; aprotic polar solvents, such as dimethyl sulfoxide, N,N-dimethylformamide, and hexamethylphosphoric triamide; etc. One of these solvents can be used, or two or more kinds thereof can be used in mixture.

Examples of reaction methods include: a method in which an aromatic ring compound or a condensed aromatic ring compound, formaldehyde, and an acid catalyst are charged at once; a method in which an aromatic ring compound or a condensed aromatic ring compound and formaldehyde are dispersed or dissolved, and then an acid catalyst is added at once or diluted with a solvent and added dropwise; and a method in which an acid catalyst is dispersed or dissolved, and then an aromatic ring compound or a condensed aromatic ring compound and formaldehyde are added at once or diluted with a solvent and added dropwise. After completion of the reaction, the product may be used as it is for the composition of the present invention for forming an organic film, or the product may be diluted in an organic solvent in order to remove unreacted raw materials, the acid catalyst, etc. present in the system, and then may be subjected to liquid-liquid separation washing and collected.

The organic solvent used in the liquid-liquid separation washing is not particularly limited, as long as it is capable of dissolving the compound and being separated into two layers when mixed with water. Examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; and the like.

As the water used for washing in the liquid-liquid separation washing, generally, what is called deionized water or ultrapure water may be used. The washing may be performed once or more, preferably approximately once to five times, because washing ten times or more does not always produce the full washing effects thereof.

In the liquid-liquid separation washing, the washing may be performed with a basic aqueous solution to remove unreacted raw materials or acidic components in the system. Specific examples of the base contained in the basic aqueous solution include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove unreacted raw materials, metal impurities, or basic components in the system. Specific examples of the acid contained in the acidic aqueous solution include inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or acidic aqueous solution, washing with neutral water may be successively performed. This washing may be performed once or more, preferably approximately once to five times. As the neutral water, deionized water, ultrapure water, or the like mentioned above may be used. The washing may be performed once or more, but if the washing is not performed sufficiently, the basic components and the acidic components may not be removed in some cases. The washing is performed preferably approximately once to five times because washing ten times or more does not always produce the full washing effects.

Further, the reaction product after the liquid-liquid separation washing can also be collected as a powder by concentrating and drying the solvent or crystallizing the reaction product under reduced pressure or normal pressure. Alternatively, the reaction product can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, and degradation of the workability can be prevented; in addition, since the amount of the solvent is not excessive, the solution can be prepared economically.

The solvent in this event is not particularly limited, as long as it is capable of dissolving the polymer. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

### [Second Method for Manufacturing Polymer (Alternative Method 1)]

The polymer (A), having the structure represented by the formula (1) as a repeating unit, can also be obtained by, as an alternative, second manufacturing method, a polymerization reaction using a raw material represented by Ar-CH₂-X. Ar is as defined above, and X represents a hydroxy group, an alkoxy group having 1 to 4 carbon atoms, or a halogen group.

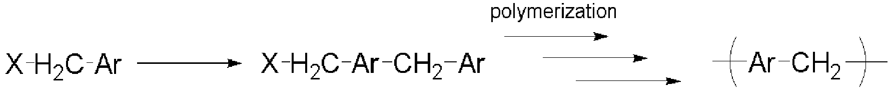

The polymerization reaction shown above is a polymerization reaction according to which the polymer can be obtained from the monomer alone. In the polycondensation reaction of the first manufacturing method, a common polymer has a repeating unit derived from monomers A and B by virtue of a dehydration reaction or the like between molecules using the usual two types of monomers A and B. On the other hand, according to the above-described method for manufacturing a polymer, it is possible to synthesize a homopolymer with one kind of monomer. In the present invention, the second manufacturing method is preferable from the viewpoint of productivity.

### [First method for manufacturing polymer: monomers form repeating unit including alternately moietyies]

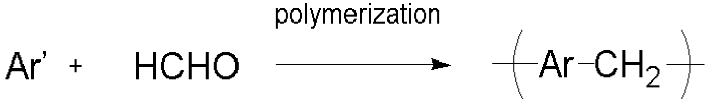

### [Second method for manufacturing polymer (alternative method 1): homopolymer of only monomer A]

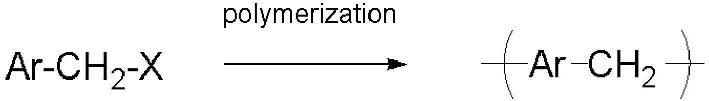

According to the reaction method shown above for synthesizing the polymer, when two monomers having a plurality of different Ars (Ar and Ar"), for example, are used, a random polymer, not having a specific repeating unit, can be synthesized by charging the monomers at once. Alternatively, a polymer having a block structure can also be synthesized by synthesizing a polymer with a monomer having Ar in a first step, and then further charging a monomer having Ar" in a second step. These synthesis methods can be selected appropriately according to required performance and so forth.

### [Two types of monomers: random type (charging at once)]

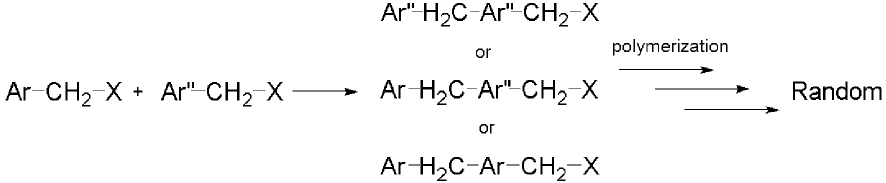

### [Two types of monomers: block type (charging in two steps)]

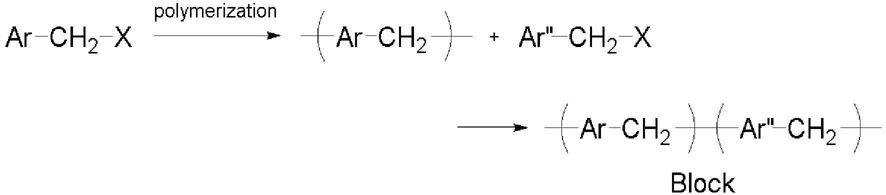

The polymer, having two kinds of repeating units represented by the formulae (2), obtained by the above-described synthesis method can provide a composition for forming a resist underlayer film that exhibits better solvent solubility than the polymer obtained by the third synthesis method (alternative method 2) described below, and therefore, is preferable. It is conjectured that solvent solubility is excellent because two different kinds of Ar and Ar" are randomly contained.

### [Method for manufacturing polymer (alternative method 2)]

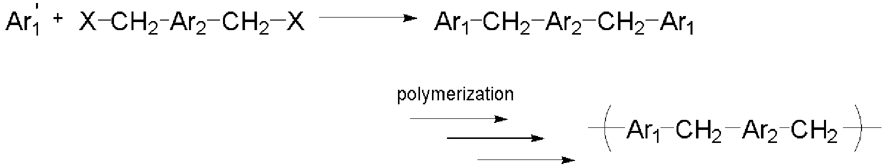

Ar', Ar₁, and Ar₂ are as defined above, and X represents a hydroxy group, an alkoxy group having 1 to 4 carbon atoms, or a halogen group.

The polymer obtained by the third manufacturing method (alternative method 2) has a repeating unit in which an aromatic ring compound or a condensed aromatic ring compound and X-CH₂-Ar₂-CH₂-X alternate. A homopolymer can also be synthesized by this synthesis method when a raw material having identical structures as Ar₁ and Ar₂ is used, but there is a flaw that it is difficult to control the molecular weight. When the molecular weight cannot be controlled, thermal decomposition behavior at the time of high-temperature treatment changes as a result, and there is a risk that dry etching resistance may be degraded.

### [Monomers A and B alternately forming repeating unit]

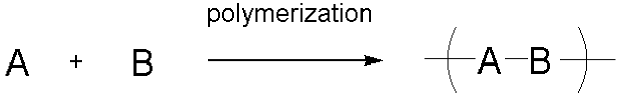

Furthermore, in the reaction method described above (second manufacturing method: alternative method 1) for synthesizing the polymer, it is also possible to introduce at once or during the reaction, as an end-capping unit, an aromatic component Arₓ (Arₓ not having a reactive unit) capable of reacting with the monomer. These methods for introducing the end-capping group can be selected appropriately by reaction rate and so forth. In conventional polymerization methods, the group can only be introduced to the ends due to the reactivity, but when this polymerization method is used, one molecule of the end-capping unit can be introduced to one molecule of the polymer. Therefore, when a polar group, such as a hydroxy group, for adjusting film-formability, adhesiveness, etc. is to be introduced in a case where the polymer is used as an end-capped resist underlayer film material, it is possible to aim at performance improvement with the minimum introduction amount, and therefore, the method is better in view of etching resistance. On the other hand, when the repeating unit structure of the polymer contains a polar group, such as a hydroxy group, many heteroatoms are contained, and therefore, many heteroatoms remain even when dissociation and recombination of carbon bonds occur through high-temperature treatment, so that there is a risk of dry etching resistance being degraded.

### [End-capping: introduction during reaction]

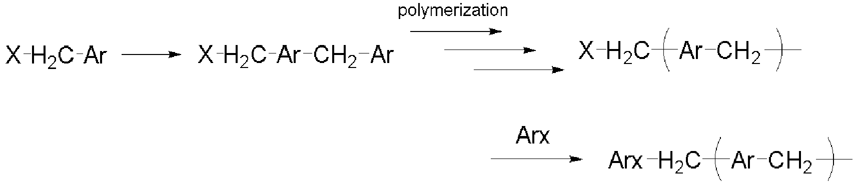

### [End-capping: charging at once]

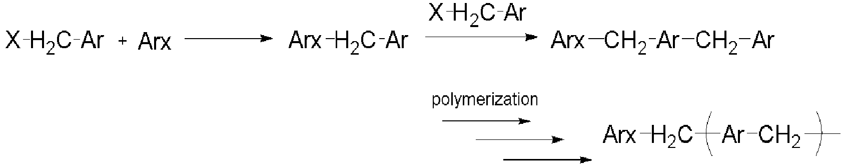

Examples of the aromatic component Arₓ include the following, and these aromatic rings may have thereon a substituent such as a vinyl group, an ethynyl group, an ethynylphenyl group, an allyl group, a propargyl group, an aryl group, an allyloxy group, and a propargyloxy group. From the viewpoint of providing etching resistance and solvent solubility, the organic group preferably has a naphthalene ring, a fluorene structure, or a carbazole structure.

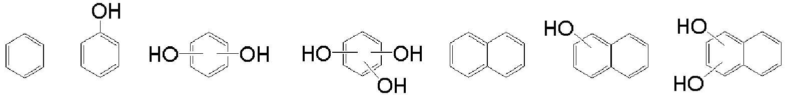

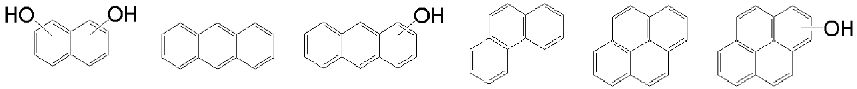

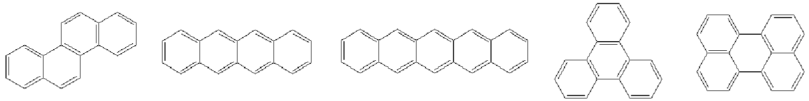

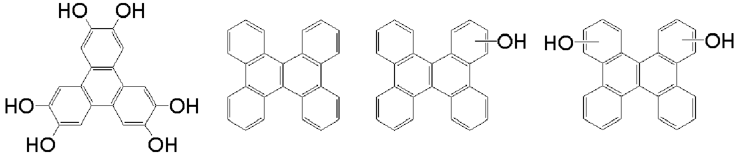

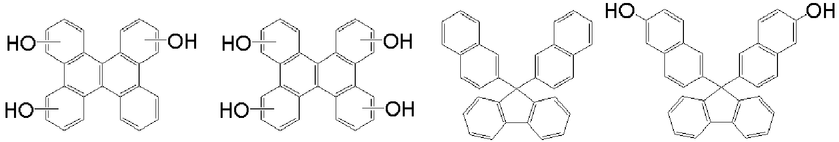

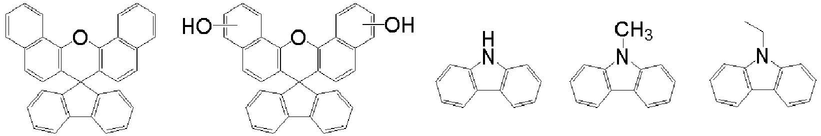

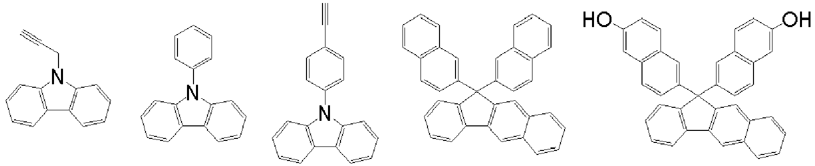

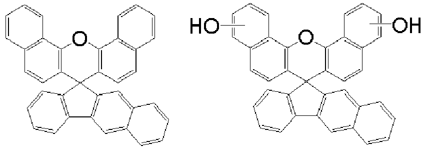

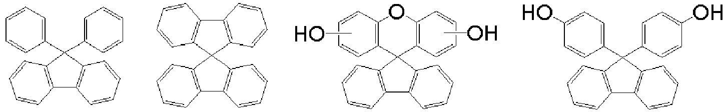

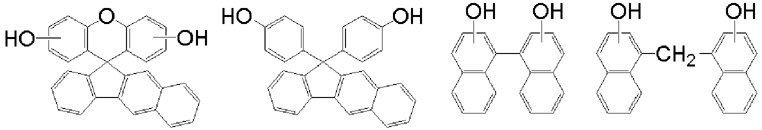

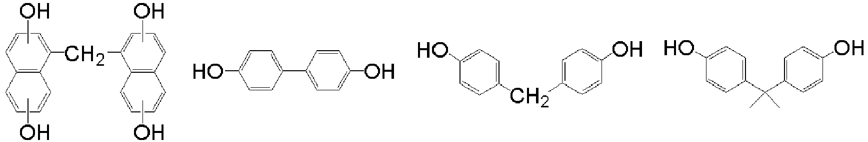

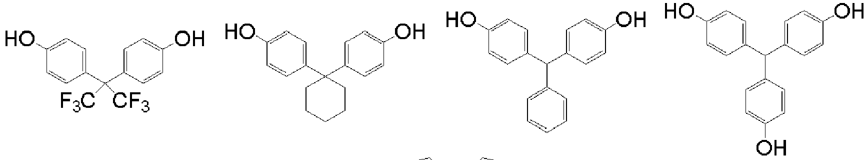

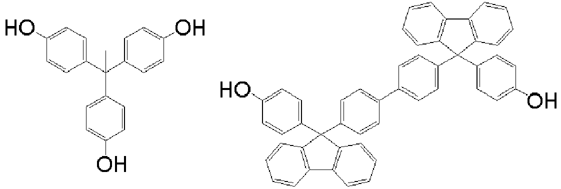

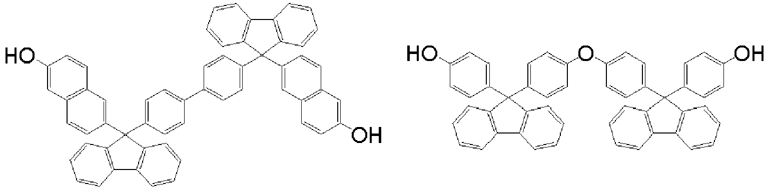

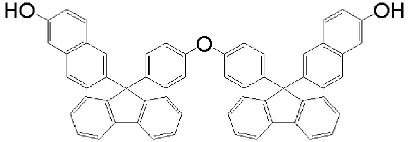

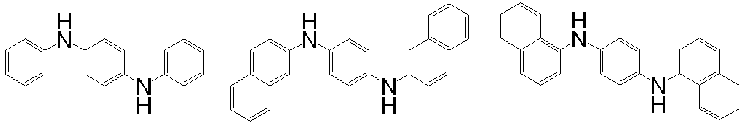

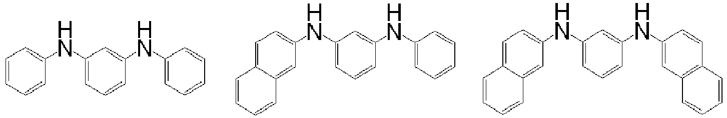

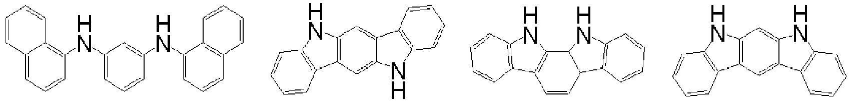

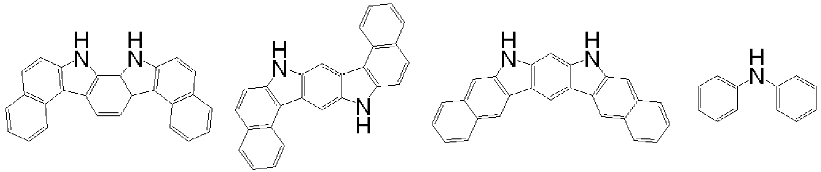

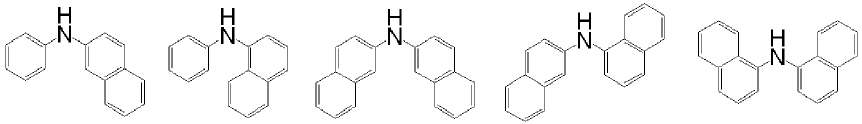

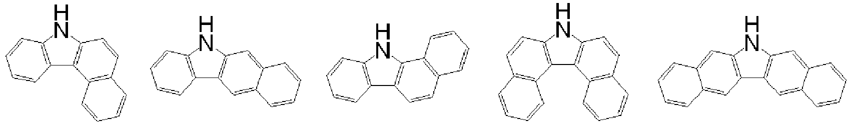

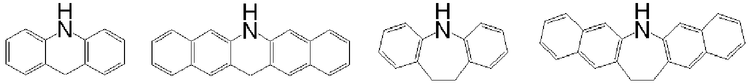

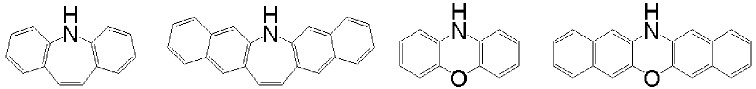

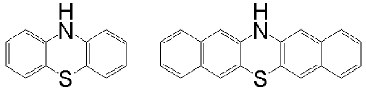

In the synthesis reaction of the polymer shown in the second manufacturing method (alternative method 1), the same reaction method and collection method as those in the first manufacturing method can be performed to manufacture the polymer, the only difference being the fact that the monomer represented by Ar-CH₂-X is used. This is also true for the third manufacturing method (alternative method 2).

### <(B) Organic Solvent>

The organic solvent (B) usable in the inventive composition for forming a resist underlayer film is not particularly limited as long as it is capable of dissolving the above-described polymer (A), and when contained, (C) a blend resin, (D) a crosslinking agent, (E) a flowability accelerator, (F) a surfactant, (G) an acid generator, (H) a plasticizer, other additives, etc. described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts, more preferably 250 to 5,000 parts based on 100 parts by mass of the polymer (A) .

### <(C) Blend Resin>

The inventive composition for forming a resist underlayer film preferably further contains a blend resin (C), being a phenolic resin or a resin containing a phenolic hydroxy group.

When the composition for forming a resist underlayer film contains the blend resin (C) having excellent thermosetting property, better film thickness uniformity can be achieved after high-temperature baking under a nitrogen atmosphere.

The blend resin (C) preferably has a molecular weight of 4,000 to 12,000. From the viewpoints of filling property and/or flatness and film thickness uniformity, the blend resin (C) preferably has a molecular weight of 6,000 to 10,000, further preferably 7,000 to 9,000. When the molecular weight is 4,000 or more, the effect of improving the film thickness uniformity of the resist underlayer film can be achieved sufficiently, and when the molecular weight is 12,000 or less, filling property and/or flatness of the composition for forming a resist underlayer film can be realized sufficiently.

The blend resin (C) is preferably contained in an amount of 10 to 100 parts by mass based on 100 parts by mass of the polymer (A). From the viewpoints of the etching resistance and film thickness uniformity of the resist underlayer film after high-temperature treatment under a nitrogen atmosphere, the blend resin (C) is preferably contained in an amount of 20 to 80 parts by mass, further preferably 40 to 60 parts by mass based on 100 parts by mass of the polymer (A).

The blend resin (C) is preferably a resin represented by any of the following general formulae (C-1), (C-2), and (C-3). 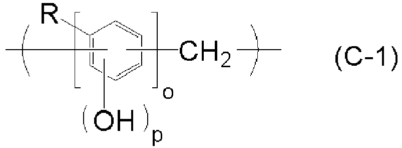 In the formula (C-1), R represents an organic group having a valency of 1 to 3, having 1 to 20 carbon atoms, and optionally containing an oxygen atom; "o" represents an integer of 1 to 3; and "p" represents an integer of 1 to 3.

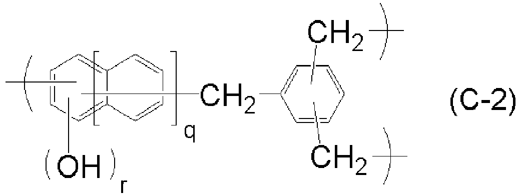

In the formula (C-2), "q" represents an integer of 0 or 1; and "r" represents an integer of 1 to 6.

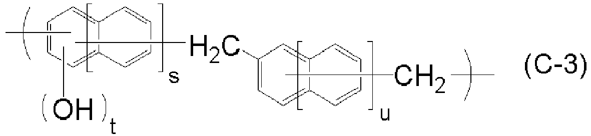

In the formula (C-3), "s" represents an integer of 0 or 1; "t" represents an integer of 1 to 6; and "u" represents an integer of 0 or 1.

In the formula (C-1), R preferably has a structure represented by one of the following formulae (C-1a). 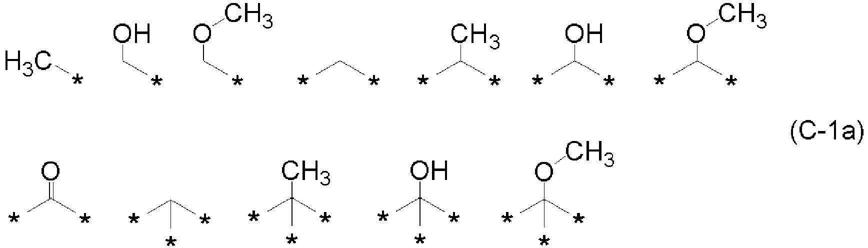 In the formulae (C-1a), "*" represents an attachment point.

In the formula (C-1), "o" is preferably 2 or 3, and "o" is further preferably 3. "p" is preferably 1 or 2, and "p" is further preferably 1.

More specific examples of the compound represented by the formula (C-1) include the following, but are not limited thereto.

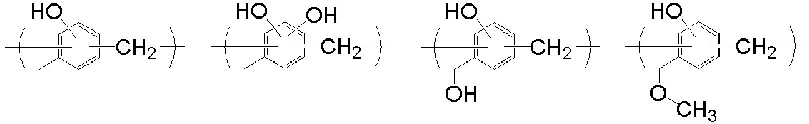

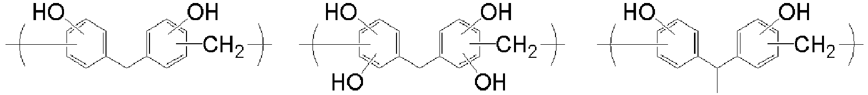

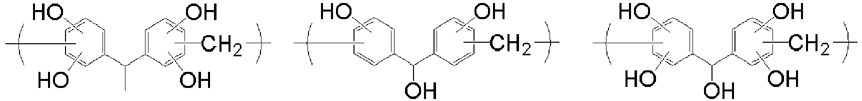

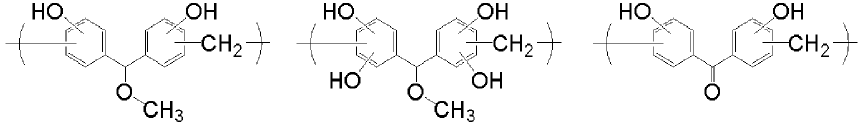

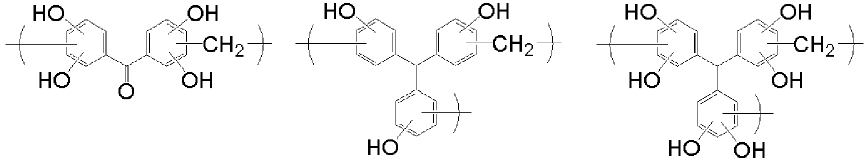

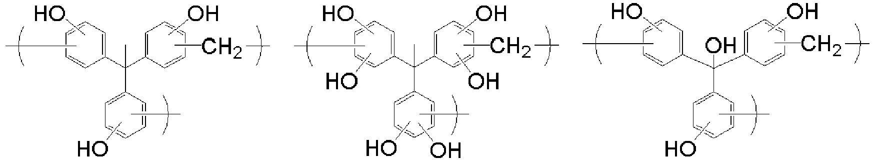

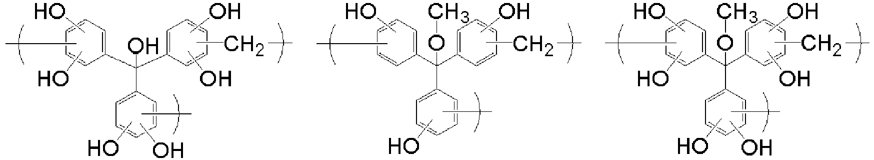

In the formula (C-2), "q" is preferably 1, "r" is preferably 1 to 3, and "r" is further preferably 2 to 3.

More specific examples of the compound represented by the formula (C-2) include the following, but are not limited thereto.

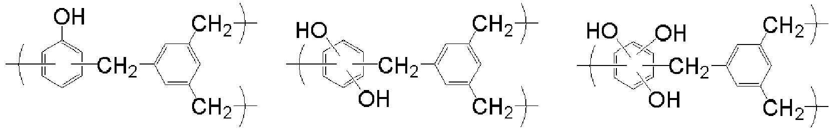

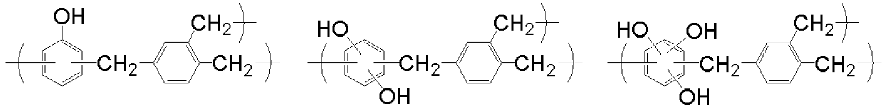

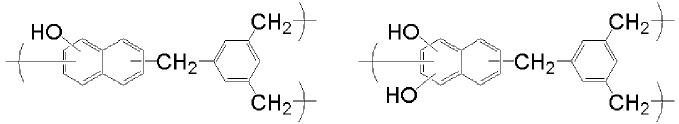

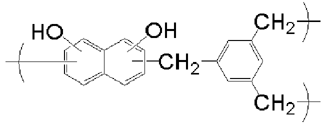

In the formula (C-3), "s" is preferably 1, "t" is preferably 1 to 3, "t" is further preferably 2 to 3, and "u" is preferably 1.

More specific examples of the compound represented by the formula (C-3) include the following, but are not limited thereto.

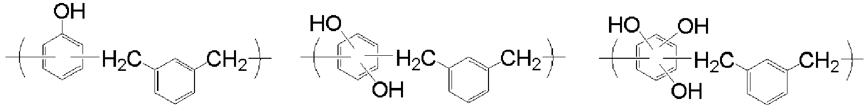

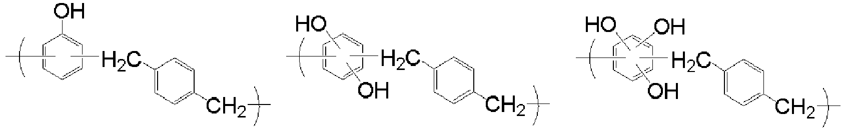

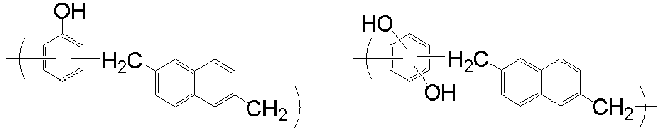

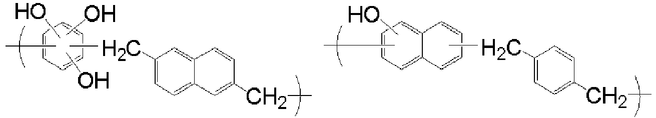

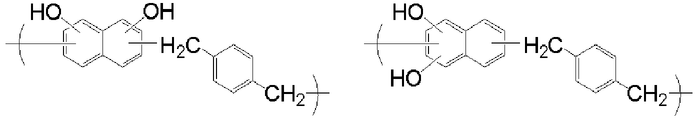

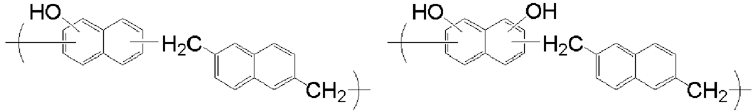

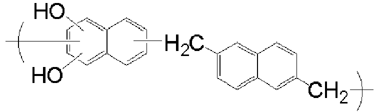

### <(D) Crosslinking Agent>

The inventive composition for forming a resist underlayer film preferably further contains a crosslinking agent (D) having a structure represented by the following general formula (4).

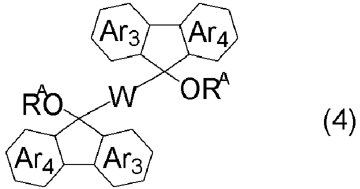

In the formula (4), Ar₃ and Ar₄ each represent a benzene ring or naphthalene ring optionally having a substituent; R^{A} represents a hydrogen atom or a monovalent organic group having 1 to 20 carbon atoms; and W represents a group represented by any of the following general formulae (5).

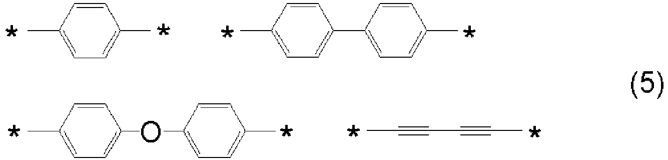

In the formulae (5), "*" represents an attachment point.

In the formula (4), Ar₃ and Ar₄ each represent a benzene ring or naphthalene ring optionally having a substituent; R^{A} represents a hydrogen atom or a monovalent organic group having 1 to 20 carbon atoms; W represents a group represented by any of the formulae (5), and from the viewpoint of the availability of raw materials, W is preferably an unsubstituted benzene ring; and R^{A} is preferably a hydrogen atom or an n-butyl group.

The crosslinking agent represented by the general formula (4) preferably has the ratio Mw/Mn (that is, dispersity) that satisfies 1.00 ≤ Mw/Mn ≤ 1.25, where Mw is a weight-average molecular weight and Mn is a number-average molecular weight measured by gel permeation chromatography in terms of polystyrene.

When the dispersity is within the above-described range, sufficient thermal flowability of the composition for forming a resist underlayer film can be achieved, it is sufficiently possible to fill fine structures formed on a substrate when the crosslinking agent is contained in the composition for forming a resist underlayer film, and moreover, it is possible to form a resist underlayer film that is flat across the entire substrate. From the definition, Mw/Mn is 1.00 when the compound is a monomolecular compound. However, for reasons of separability in GPC, the measured value exceeds 1.00 in some cases. Generally, it is extremely difficult to bring Mw/Mn close to 1.00 in a polymer having a repeating unit unless a special polymerization method is used, there is a molecular weight distribution, and Mw/Mn becomes a value greater than 1. In the present invention, 1.00 ≤ Mw/Mn ≤ 1.25 has been defined as an index indicating monomerism in order to distinguish between a monomolecular compound and a polymer.

In the composition, the crosslinking agent (D) is preferably contained in an amount of 5 to 50 parts by mass, more preferably 10 to 40 parts by mass, and further preferably 15 to 30 parts by mass based on 100 parts by mass of the polymer (A).

### <(E) Flowability Accelerator>

The inventive composition for forming a resist underlayer film preferably further contains a flowability accelerator (E) having a weight reduction rate of less than 30% on heating from 30°C to 190°C and having a weight reduction rate of 98% or more on heating from 30°C to 350°C.

A flowability accelerator having a weight reduction rate of less than 30% on heating from 30°C to 190°C and having a weight reduction rate of 98% or more on heating from 30°C to 350°C is preferable because low viscosity can be sufficiently maintained by virtue of the suppression of evaporation during heat treatment, the flowability accelerator has excellent thermal flowability, and little flowability accelerator remains in the resist underlayer film after baking. Herein, the weight reduction rate is based on the value determined by TG (thermogravimetry) measurement using a differential thermal analyzer.

The upper limit of the temperature range in which the flowability accelerator (E) has a weight reduction rate of less than 30% is more preferably 210°C, and further preferably 230°C. When the temperature range in which the flowability accelerator (E) has a weight reduction rate of less than 30% is the above-described range, filling property and/or flatness can be further enhanced.

The temperature at which the flowability accelerator (E) has a weight reduction rate of 98% or more is more preferably 330°C, and particularly preferably 310°C. When the temperature at which the flowability accelerator has a weight reduction rate of 98% or more is in the above-described temperature range, the flowability accelerator remaining in the resist underlayer film after baking can be further reduced.

By such a flowability accelerator (E) being contained, the thermal flowability from the start of the heat treatment of the composition for forming a resist underlayer film to the curing by a crosslinking reaction is enhanced, and therefore, better filling property and/or better flatness can be exhibited. Meanwhile, the flowability accelerator (E) is reduced by evaporation caused by the heat treatment and so forth, and therefore, there is no risk of etching resistance or optical characteristics being degraded.

Examples of further preferable embodiments of the flowability accelerator (E) include one or more compounds selected from the group consisting of compounds represented by the following general formulae (i) to (iii).

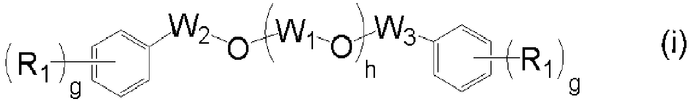

In the formula (i), each R₁ independently represents a hydrogen atom, a hydroxy group, or an organic group having 1 to 10 carbon atoms and optionally being substituted; W₁ represents a phenylene group or a divalent group represented by the following general formula (i-1); W₂ and W₃ each represent a single bond or a divalent group represented by either of the following general formulae (i-2); "g" represents an integer of 1 to 5; and "h" represents an integer of 0 to 10.

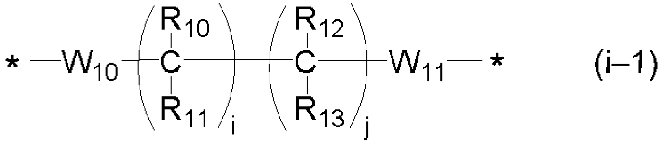

In the formula (i-1), "*" represents an attachment point; R₁₀, R₁₁, R₁₂, and R₁₃ each represent a hydrogen atom, a hydroxy group, or an organic group having 1 to 10 carbon atoms; W₁₀ and W₁₁ each independently represent a single bond or a carbonyl group; and "i" and "j" each represent an integer of 0 to 10, provided that i + j ≥ 1.

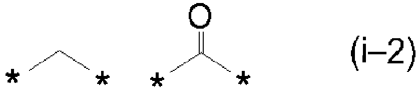

In the formulae (i-2), "*" represents an attachment point.

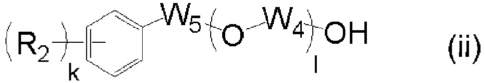

In the formula (ii), each R₂ independently represents a hydrogen atom or an organic group having 1 to 10 carbon atoms and optionally being substituted; W₄ represents a divalent group represented by the following general formula (ii-1); W₅ represents a single bond or a divalent group represented by either of the following general formulae (ii-2); "k" represents an integer of 0 to 5; and "l" represents an integer of 2 to 10.

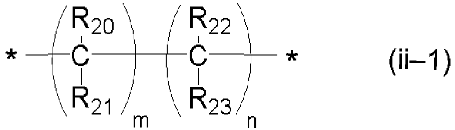

In the formula (ii-1), "*" represents an attachment point; R₂₀, R₂₁, R₂₂, and R₂₃ each represent a hydrogen atom, a hydroxy group, or an organic group having 1 to 10 carbon atoms; and "m" and "n" each represent an integer of 0 to 10, provided that m + n ≥ 1.

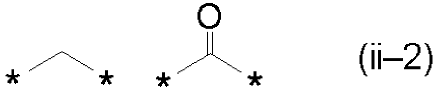

In the formulae (ii-2), "*" represents an attachment point.

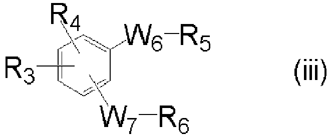

In the formula (iii), R₃ and R₄ each represent a hydrogen atom, a hydroxy group, or an organic group having 1 to 10 carbon atoms, optionally being substituted, and optionally being bonded to each other to form a cyclic structure; R₅ and R₆ each represent an organic group having 1 to 10 carbon atoms, R₅ being a group containing either an aromatic ring or a divalent group represented by the following general formula (iii-1); and W₆ and W₇ each represent a single bond or a divalent group represented by either of the following general formulae (iii-2), at least one of W₆ and W₇ being a divalent group represented by either of the general formulae (iii-2).

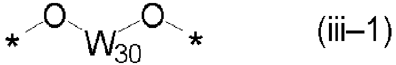

In the formula (iii-1), "*" represents an attachment point; and W₃₀ represents an organic group having 1 to 4 carbon atoms.

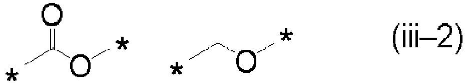

In the formula (iii-2), "*" represents an attachment point.

In the general formula (i), each R₁ independently represents a hydrogen atom, a hydroxy group, or an organic group having 1 to 10 carbon atoms and optionally being substituted.

Here, "organic group" in the present invention means a group containing at least one carbon atom and further containing a hydrogen atom, and unless stated otherwise, a nitrogen, oxygen, sulfur, silicon, halogen atom, etc. may also be contained.

R₁ may be of one kind, or multiple kinds may be present in mixture. More specific examples of R₁ include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, R₁ is more preferably a hydrogen atom.

W₁ represents a phenylene group or a divalent group represented by the general formula (i-1). W₂ and W₃ each represent a single bond or a divalent group represented by either of the general formulae (i-2). W₂ and W₃ each represent a single bond or a divalent group represented by either of the following general formulae (i-2). "h" represents an integer of 0 to 10, and each "g" independently represents an integer of 1 to 5.

In the formula (i-1), R₁₀, R₂₂, R₁₂, and R₁₃ are each, more specifically, a hydrogen atom, a hydroxy group, or an organic group having 1 to 10 carbon atoms. More specific examples include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, R₁₀, R₁₁, R₁₂, and R₁₃ are more preferably each a hydrogen atom or a methyl group, further preferably a hydrogen atom.

Each of W₁₀ and W₂₁ independently represent a single bond or a carbonyl group. "i" and "j" each represent an integer of 0 to 10 and satisfy i+j ≥ 1.

In the formula (ii), R₂ may be of one kind, or multiple kinds may be present in mixture. More specific examples of R₂ include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, R₂ is more preferably a hydrogen atom.

In the formula (ii), W₄ represents a divalent group represented by the general formula (ii-1) . W₅ represents a single bond or one of the divalent groups represented by the general formulae (ii-2). "k" represents an integer of 0 to 5, and "l" represents an integer of 2 to 10.

In the formula (ii-1), more specific examples of R₂₀, R₂₁, R₂₂, and R₂₃ include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, each of R₂₀, R₂₁, R₂₂, and R₂₃ more preferably represents a hydrogen atom or a methyl group, and further preferably a hydrogen atom.

In the formula (ii-1), "m" and "n" each represent an integer of 0 to 10 and satisfy m+n ≥ 1.

In the formula (iii), R₃ and R₄ each represent a hydrogen atom, a hydroxy group, or an organic group having 1 to 10 carbon atoms. More specific examples include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, R₃ and R₄ more preferably each represent a hydrogen atom.

In the formula (iii), R₆ represents an organic group having 1 to 10 carbon atoms. In the formula (iii), R₅ represents an organic group having 1 to 10 carbon atoms, and is a group containing an aromatic ring or a divalent group represented by the general formula (iii-1). Examples of the organic group having 1 to 10 carbon atoms include the groups given as examples of R₃ and R₄.

In the formula (iii), W₆ and W₇ each represent a single bond or a divalent group represented by one of the following general formulae (iii-2), and at least one of W₆ and W₇ is a divalent group represented by one of (iii-2).

In the formula (iii-1), W₃₀ represents an organic group having 1 to 4 carbon atoms. More specific examples include a methylene group, an ethylene group, a propylene group, a butylene group, a trimethylene group, and a tetramethylene group. In particular, W₃₀ is more preferably an ethylene group.

Further specific examples of the compound represented by the general formula (i) include the following, but are not limited thereto.

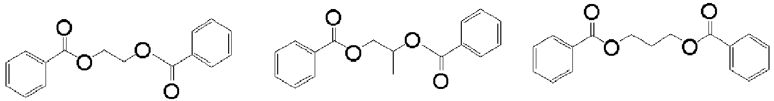

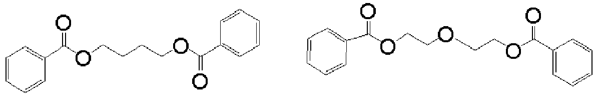

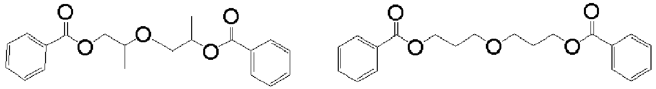

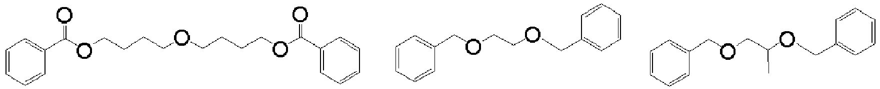

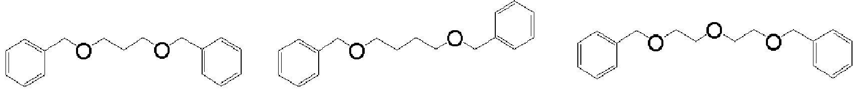

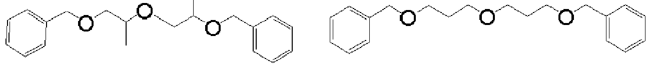

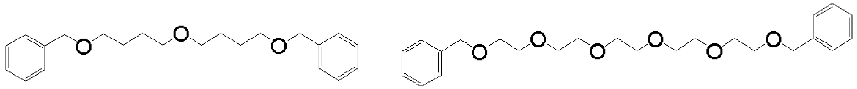

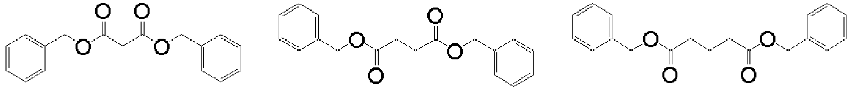

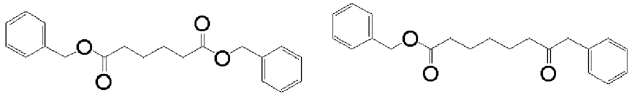

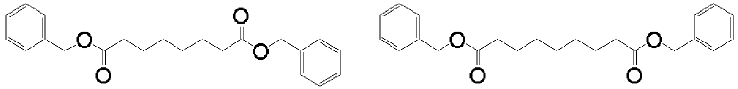

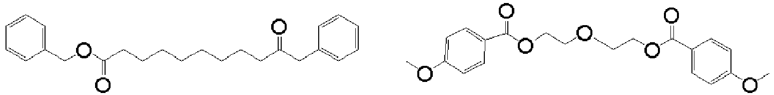

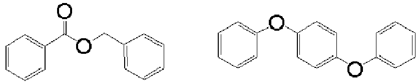

Further specific examples of the compound represented by the general formula (ii) include the following, but are not limited thereto.

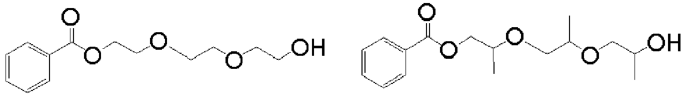

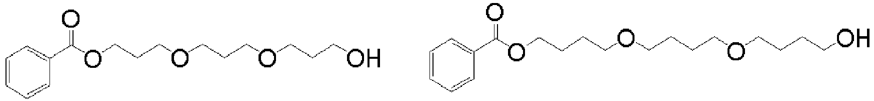

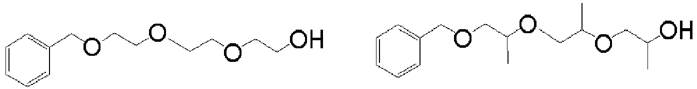

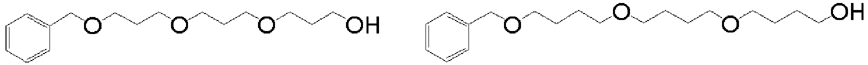

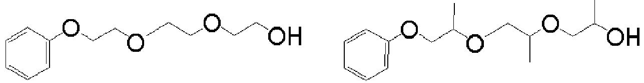

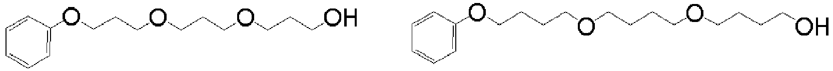

Further specific examples of the compound represented by the general formula (iii) include the following, but are not limited thereto.

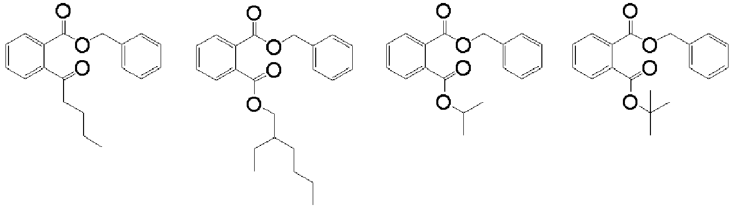

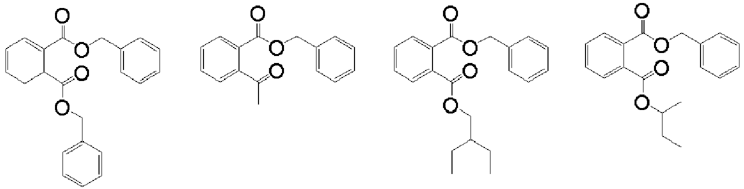

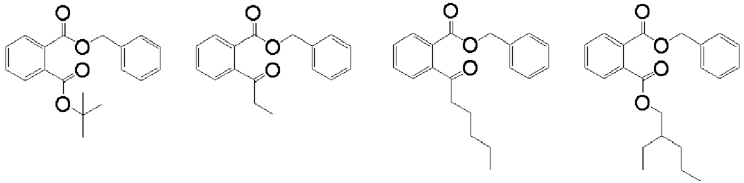

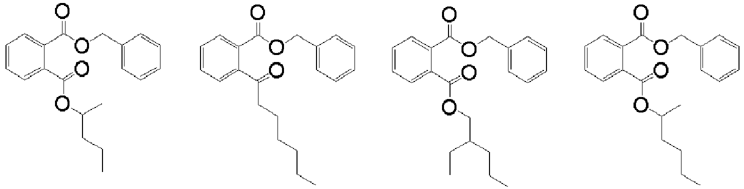

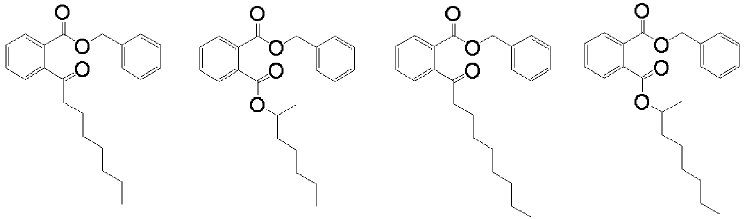

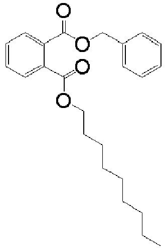

Comprehensively considering the film-formability, properties of filling and/or planarizing a substrate, etc. of the composition for forming a resist underlayer film, the flowability accelerator (E) to be contained in the inventive composition for forming a resist underlayer film is preferably an aromatic-group-containing compound having a benzyl group or a benzoyl group, particularly preferably an aromatic-group-containing compound shown below.
(E-i) (Poly)ethylene glycol dibenzoate
(E-ii) (Poly)ethylene glycol dibenzyl ether
(E-iii) (Poly)propylene glycol dibenzyl ether
(E-iv) (Poly)butylene glycol dibenzyl ether
(E-v) Linear aliphatic dibenzyl dicarboxylate
(E-vi) (Poly)ethylene glycol monobenzyl ether
(E-vii) (Poly)phenyl ether

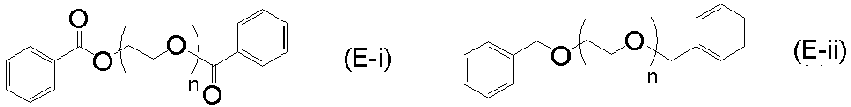

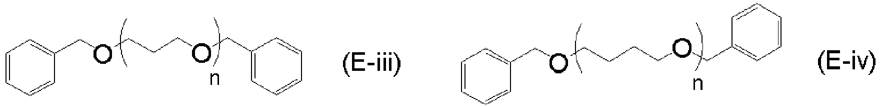

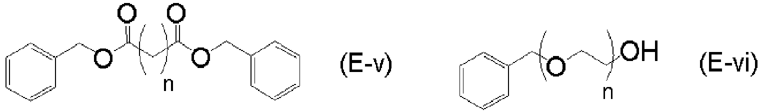

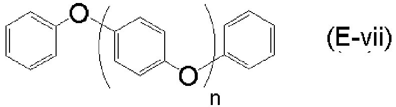

Note that the "n" in the above formulae is an integer at which the molecular weight is within the range of 500 or less, and applies only in these formulae.

The flowability accelerator (E) that can be contained in the inventive composition for forming a resist underlayer film has a structure having both a hydrophobic moiety including an aromatic ring and a hydrophilic moiety (including the following structure (iii-1), for example). Therefore, the flowability accelerator has excellent compatibility with the polymer (A), the organic solvent (B), and other additives, and the flowability of the composition can be improved without degradation in film-formability or storage stability. 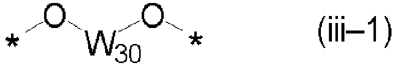 In the formula, "*" represents an attachment point; and W₃₀ represents an organic group having 1 to 4 carbon atoms.

The amount of the flowability accelerator (E) to be contained is preferably 5 to 100 parts by mass, more preferably 10 to 50 parts by mass relative to 100 parts by mass of the polymer. When the amount of the flowability accelerator contained is 10 mass% or more, the flowability of the composition for forming a resist underlayer film can be sufficiently enhanced. When the contained amount of the flowability accelerator relative to the polymer is too low, the effect of improving the thermal flowability of the resist underlayer film may be too low. On the other hand, when the contained amount of the flowability accelerator is excessive, there may be inconvenient effects on the film-formability and dry etching resistance of the obtained coating film.

One kind of the aromatic-group-containing compound can be used as the flowability accelerator (E), or two or more kinds thereof can be used in combination.

### <Other Components>

### [Other Crosslinking Agents]

The inventive composition for forming a resist underlayer film can also contain a common crosslinking agent besides the crosslinking agent (D), which is characterized by the structure of the general formula (4). The crosslinking agent to be used is not particularly limited, and various known crosslinking agents can be widely used. Examples thereof include polynuclear phenol-based, such as methylol or alkoxymethyl-based crosslinking agents (polynuclear phenol-based crosslinking agents), melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and epoxy-based crosslinking agents. When the crosslinking agent is contained, the contained amount is preferably 1 to 50 parts, more preferably 5 to 30 parts relative to 100 parts by mass of the polymer (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide. Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1). 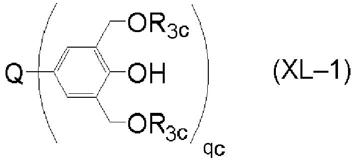 In the formula, Q represents a single bond or a q_{c}-valent hydrocarbon group having 1 to 20 carbon atoms. R_{3c} represents a hydrogen atom or an alkyl group having 1 to 20 carbon atoms. "q_{c}" represents an integer of 1 to 5.

Q represents a single bond or a hydrocarbon group having a valency of q_{c} and having 1 to 20 carbon atoms. "q_{c}" represents an integer of 1 to 5, more preferably 2 or 3. Specific examples of Q include groups obtained by removing "q_{c}" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R_{3c} represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. R_{3c} is preferably a hydrogen atom or a methyl group.

Specific examples of the compounds represented by the general formula (XL-1) include the following compounds. Among these, a hexamethoxymethylated derivative of triphenolmethane, triphenolethane, 1,1,1,-tris(4-hydroxyphenyl)ethane, and tris(4-hydroxyphenyl)-1-ethyl-4-isopropylbenzene are preferable from the viewpoint of improving the curability and film thickness uniformity of the organic film. R_{3c} is as defined above.

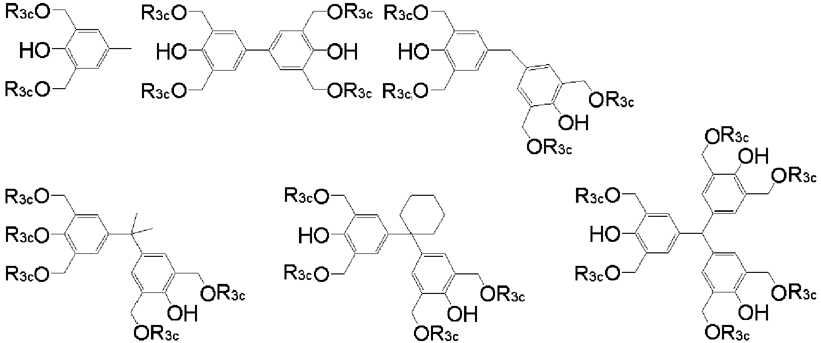

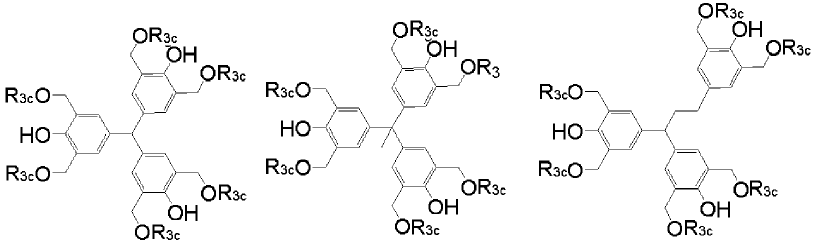

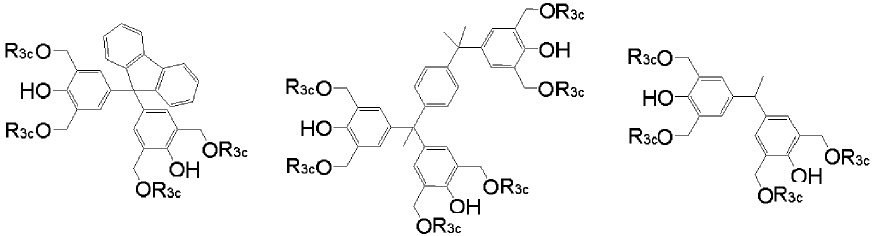

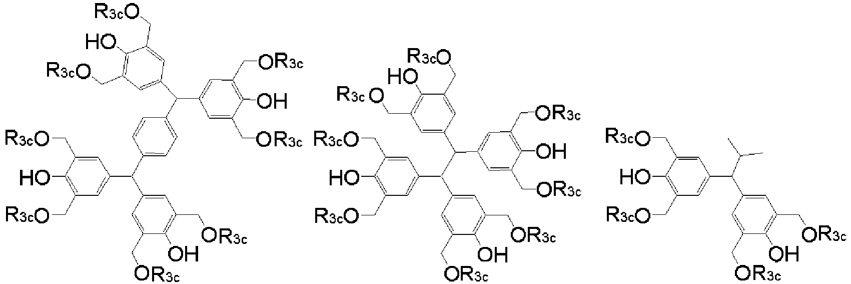

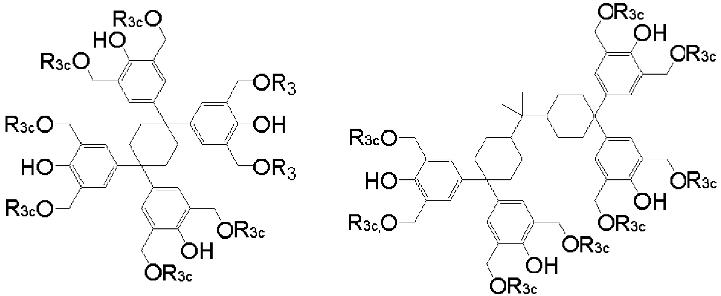

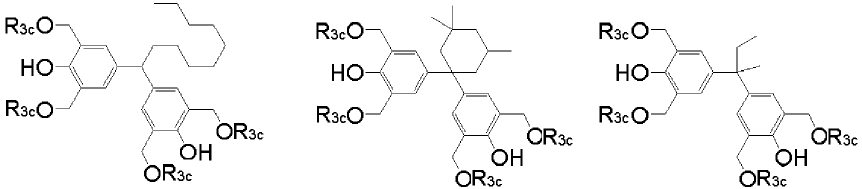

### [(F) Surfactant]

A surfactant may be contained in the inventive composition for forming a resist underlayer film in order to improve coating property in spin-coating. Examples of the surfactant include those disclosed in [0142] to [0147] of JP2009-269953A. When the surfactant is contained, the contained amount is preferably 0.01 to 10 parts, more preferably 0.05 to 5 parts per 100 parts by mass of the polymer (A).

### [(G) Acid Generator]

An acid generator may be contained in the inventive composition for forming a resist underlayer film in order to promote a curing reaction further. The acid generator can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When the acid generator is contained, the contained amount is preferably 0.05 to 50 parts, more preferably 0.1 to 10 parts relative to 100 parts by mass of the polymer (A).

### [(H) Plasticizer]

A plasticizer may be contained in the inventive composition for forming a resist underlayer film in order to improve further the filling and/or planarizing properties. The plasticizer is not particularly limited, and various known plasticizers can be widely used. Examples of the plasticizer include low molecular weight compounds, such as phthalate esters, adipate esters, phosphate esters, trimellitate esters, and citrate esters; and polymers, such as polyether-based polymers, polyester-based polymers, and polyacetal-based polymers disclosed in JP2013-253227A. When the plasticizer is contained, the contained amount is preferably 1 to 100 parts, more preferably 5 to 30 parts, per 100 parts by mass of the polymer (A).

In addition, in the inventive composition for forming a resist underlayer film, it is preferable to use, as an additive for imparting filling and/or planarizing properties in the same manner as the plasticizer, for example, a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a). 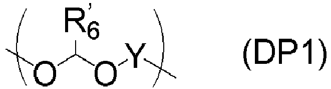 In the formula, R₆' represents a hydrogen atom or a saturated or unsaturated monovalent organic group having 1 to 30 carbon atoms, the organic group optionally being substituted. Y represents a saturated or unsaturated divalent organic group having 2 to 30 carbon atoms. 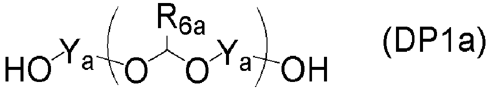 In the formula, R₆ₐ represents an alkyl group having 1 to 4 carbon atoms. Yₐ represents a saturated or unsaturated divalent hydrocarbon group having 4 to 10 carbon atoms and optionally having an ether bond. "n" represents an average repeating unit number of 3 to 500.

### <Patterning Process Using Composition for Forming Resist Underlayer Film>

### <Patterning Process Using Composition for Forming Resist Underlayer Film>

The present invention also provides a patterning process for forming a pattern in a substrate to be processed, including the steps of:
(I-1) applying the above-described composition for forming a resist underlayer film onto a substrate to be processed to obtain a coating film, then heating the coating film to form a resist underlayer film;
(I-2) forming a resist upper layer film on the resist underlayer film by using a photoresist material;
(I-3) subjecting the resist upper layer film to pattern exposure and then to development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The patterning process according to a two-layer resist process makes it possible to form a fine pattern in a body to be processed (substrate to be processed).

The present invention also provides a patterning process for forming a pattern in a substrate to be processed, including the steps of:
(II-1) applying the above-described composition for forming a resist underlayer film onto a substrate to be processed to obtain a coating film, then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then to development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

The patterning process according to a three-layer resist process makes it possible to form a fine pattern in a body to be processed with high precision.

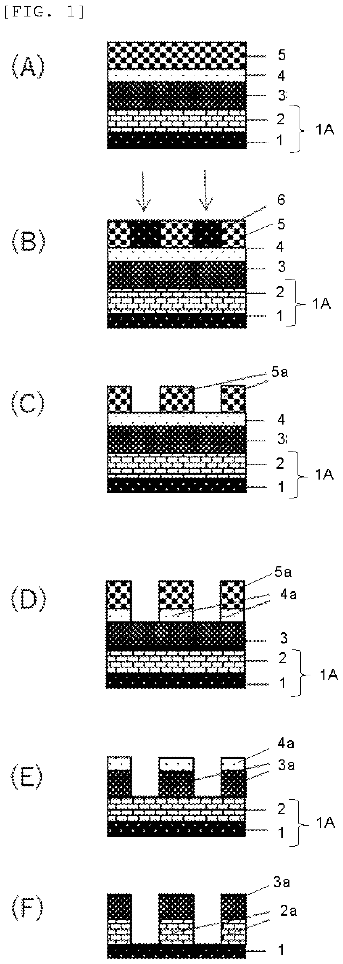

With reference to FIG. 1, an example of a patterning process according to a three-layer resist process will be described. Firstly, the laminate shown in FIG. 1(A) is formed. Specifically, firstly, the inventive composition for forming a resist underlayer film is applied onto a layer 2 to be processed of a substrate 1A to be processed, including a support substrate 1 and the layer 2 to be processed formed thereon, to obtain a coating film, and then the coating film is heated to form a resist underlayer film 3. Next, a resist middle layer film 4 is formed on the resist underlayer film 3 by using a resist middle layer film material. Then, a resist upper layer film 5 is formed on the resist middle layer film 4 by using a photoresist material. Subsequently, as in FIG. 1(B), an exposure portion 6 is formed in the resist upper layer film 5 by pattern exposure. Then, the exposure portion 6 is developed with a developer to form a resist upper layer film pattern 5a in the resist upper layer film 5 as in FIG. 1(C). Subsequently, as in FIG. 1(D), a silicon-containing resist middle layer film pattern 4a is transferred to the resist middle layer film 4 by dry etching while using the resist upper layer film 5 having the formed pattern 5a as a mask. Subsequently, as in FIG. 1(E), a resist underlayer film pattern 3a is transferred to the resist underlayer film 3 by dry etching while using the resist middle layer film 4 having the transferred pattern 4a as a mask. Then, as in FIG. 1(F), the layer 2 to be processed of the substrate 1A to be processed is processed while using the resist underlayer film 3 having the formed pattern 3a as a mask to form a pattern 2a on the substrate 1 to be processed.

The silicon-containing resist middle layer film in the three-layer resist process exhibits etching resistance with respect to an oxygen-based gas. Therefore, the dry etching of the resist underlayer film that is performed while using the silicon-containing resist middle layer film as a mask in the three-layer resist process is preferably performed using an etching gas mainly containing an oxygen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides, as a patterning process according to a four-layer resist process using the above-described inventive composition for forming a resist underlayer film, a patterning process for forming a pattern in a substrate to be processed, including the steps of:
(III-1) applying the inventive composition for forming a resist underlayer film onto a substrate to be processed to obtain a coating film, then heating the coating film to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

Alternatively, an inorganic hard mask may be formed instead of the silicon-containing resist middle layer film. In this case, a semiconductor device circuit pattern can be formed on a substrate, at least, by:
forming a resist underlayer film on a body to be processed by using the inventive composition for forming a resist underlayer film;
forming an inorganic hard mask selected from a silicon oxide film, a silicon nitride film, and a silicon oxynitride film on the resist underlayer film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the resist underlayer film while using the inorganic hard mask having the formed pattern as a mask; and
furthermore, etching the body to be processed while using the resist underlayer film having the formed pattern as a mask to form the pattern in the body to be processed.

As described above, when the inorganic hard mask is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300°C to 500°C. Thus, the resist underlayer film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the resist upper layer film is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the resist upper layer film is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyltin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in ALD. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the resist underlayer film is etched while using the obtained silicon-containing resist middle layer film pattern or inorganic hard mask pattern as a mask. The etching of the resist underlayer film is preferably performed using an etching gas mainly containing an oxygen-based gas.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained from the inventive composition for forming a resist underlayer film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate (support substrate), and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process, using the inventive composition for forming a resist underlayer film, it is preferable to use a substrate to be processed having a structure or step having a height of 30 nm or more. As described above, the inventive composition for forming a resist underlayer film is excellent in filling and/or planarizing properties, and therefore, a flat cured film can be formed even when the substrate to be processed has a structure or step (irregularities) having a height of 30 nm or more. The height of the structure or step that the substrate to be processed has is preferably 30 nm or more, more preferably 50 nm or more, and more preferably 100 nm or more. In a method for processing a stepped substrate having a pattern of the above-described height, by forming a film of the inventive composition for forming a resist underlayer film to perform filling and/or planarization, it is possible to achieve a uniform film thickness in the subsequently formed resist middle layer film and resist upper layer film, and therefore, exposure depth margin (DOF) at the time of photolithography can be ensured easily, and this is extremely favorable.

### <Method for Forming Resist Underlayer Film>

The present invention provides a method for forming a resist underlayer film that serves as an organic flat film used in a semiconductor device manufacturing process, the method including:
applying the inventive composition for forming a resist underlayer film onto a substrate to be processed by spin-coating to obtain a coating film; and
heating the coating film at a temperature of 450°C or higher and 800°C or lower for 10 to 600 seconds to cure the coating film and form a resist underlayer film.

The present invention also provides a method for forming a resist underlayer film that serves as an organic flat film used in a semiconductor device manufacturing process, the method including:
applying the inventive composition for forming a resist underlayer film onto a substrate to be processed by spin-coating to obtain a coating film; and
heating the coating film under an atmosphere with an oxygen concentration of 1% or more and 21% or less to cure the coating film and form a resist underlayer film.

Alternatively, present invention also provides a method for forming a resist underlayer film that serves as an organic flat film used in a semiconductor device manufacturing process, the method including:
applying the inventive composition for forming a resist underlayer film onto a substrate to be processed by spin-coating to obtain a coating film; and
heating the coating film under an atmosphere with an oxygen concentration of less than 1% to cure the coating film and form a resist underlayer film.

In the inventive method for forming a resist underlayer film, the above-described resist underlayer film material is applied onto the substrate to be processed by a spin-coating method or the like. By employing spin-coating etc., excellent filling property can be achieved. After the spin-coating, the organic solvent is evaporated, and in order to prevent mixing with the resist upper layer film or the resist middle layer film, heating (baking) is performed for promoting the crosslinking reaction. The baking is preferably performed at a temperature of 100°C or higher and 800°C or lower, more preferably 300°C or higher and 800°C or lower, and further preferably 450°C or higher and 800°C or lower. The baking time is preferably 10 seconds to 600 seconds, more preferably 10 to 300 seconds. By appropriately adjusting the baking temperature and time within the above ranges, it is possible to achieve the planarizing and/or filling properties and curing properties, such as dry etching resistance and heat resistance, suitable for the intended usage. By performing the baking within the temperature range of 450°C or higher and 800°C or lower, particularly excellent dry etching resistance can be achieved. When the baking temperature is 100°C or higher, curing progresses sufficiently, and mixing with the resist upper layer film or the resist middle layer film can be suppressed. When the baking temperature is 800°C or lower, thermal decomposition of the base resin can be suppressed, and therefore, film thickness does not decrease, so that the film surface can be made uniform.

As the atmosphere during the heat treatment, it is possible to select, as necessary, an oxygen-containing atmosphere (oxygen concentration: 1% to 210), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

In the method for forming a resist underlayer film, using the inventive composition for forming a resist underlayer film, it is preferable to use a substrate to be processed having a structure or step having a height of 30 nm or more. As described above, the inventive composition for forming a resist underlayer film is excellent in filling and/or planarizing properties, and therefore, a flat cured film can be formed even when the substrate to be processed has a structure or step (irregularities) having a height of 30 nm or more. The height of the structure or step that the substrate to be processed has is preferably 30 nm or more, more preferably 50 nm or more, and more preferably 100 nm or more. In a method for processing a stepped substrate having a pattern of the above-described height, by forming a film of the inventive composition for forming a resist underlayer film to perform filling and/or planarization, it is possible to achieve a uniform film thickness in the subsequently formed resist middle layer film and resist upper layer film, and therefore, exposure depth margin (DOF) at the time of photolithography can be ensured easily, and this is extremely favorable.

### EXAMPLES

The present invention is further specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### Synthesis Examples: Synthesis of Polymer (A)

For the synthesis of the polymers (A1) to (A7), compound group b ((b1) to (b6)) shown below was used.

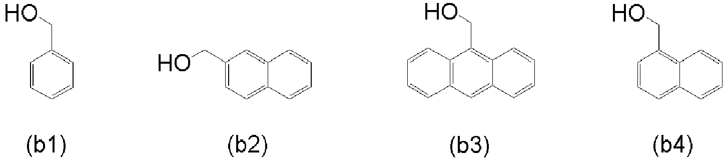

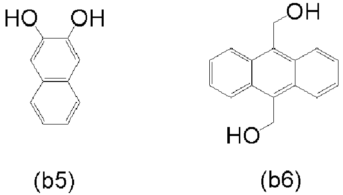

### [Synthesis Example 1] Synthesis of Polymer (A1)

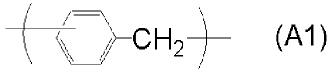

Under a nitrogen atmosphere, 31.2 g of the compound (b1) and 300 g of 1,2-dichloroethane were mixed together and then homogeneously dispersed at an internal temperature of 60°C. To the obtained mixture, 41.6 g of methanesulfonic acid was added dropwise over 1 hour, and the mixture was heated and stirred at an internal temperature of 70°C for 6 hours. The mixture was cooled to room temperature, then 400 g of 1,2-dichloroethane was added thereto, and then insoluble matter was removed by filtration. The collected filtrate was washed six times with 200 g of pure water, and the organic layer was evaporated under reduced pressure to dryness. After adding 150 g of THF to the residue to yield a homogeneous solution, a crystal was precipitated in 500 g of methanol. The precipitated crystal was separated by filtration, washed with 300 g of methanol and 300 g of diisopropyl ether in this order, and collected. The collected crystal was vacuum-dried at 70°C to obtain a polymer (A1).

The weight-average molecular weight (Mw) and the dispersity (Mw/Mn) were determined by GPC, and the following results were obtained.
(A1): Mw=2,710, Mw/Mn=1.86

### [Synthesis Example 2] Synthesis of Polymer (A2)

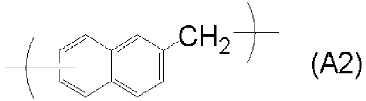

Under a nitrogen atmosphere, 45.6 g of the compound (b2) and 300 g of 1,2-dichloroethane were mixed together and then homogeneously dispersed at an internal temperature of 60°C. To the obtained mixture, 41.6 g of methanesulfonic acid was added dropwise over 1 hour, and the mixture was heated and stirred at an internal temperature of 70°C for 6 hours. After cooling the mixture to room temperature, 400 g of 1,2-dichloroethane was added thereto, and then insoluble matter was removed by filtration. The collected filtrate was washed six times with 200 g of pure water, and the organic layer was evaporated under reduced pressure to dryness. After adding 150 g of THF to the residue to yield a homogeneous solution, a crystal was precipitated in 500 g of methanol. The precipitated crystal was separated by filtration, washed with 300 g of methanol and 300 g of diisopropyl ether in this order, and collected. The collected crystal was vacuum-dried at 70°C to obtain a polymer (A2).

The weight-average molecular weight (Mw) and the dispersity (Mw/Mn) were determined by GPC, and the following results were obtained.
(A2): Mw=2,030, Mw/Mn=1.56

### [Synthesis Example 3] Synthesis of Polymer (A3)

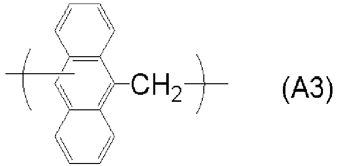

Under a nitrogen atmosphere, 60.0 g of the compound (b3) and 300 g of 1,2-dichloroethane were mixed together and then homogeneously dispersed at an internal temperature of 60°C. To the obtained mixture, 55.4 g of methanesulfonic acid was added dropwise over 1 hour, and the mixture was heated and stirred at an internal temperature of 70°C for 6 hours. After cooling the mixture to room temperature, 400 g of 1,2-dichloroethane was added thereto, and then insoluble matter was removed by filtration. The collected filtrate was washed six times with 200 g of pure water, and the organic layer was evaporated under reduced pressure to dryness. After adding 150 g of THF to the residue to yield a homogeneous solution, a crystal was precipitated in 500 g of methanol. The precipitated crystal was separated by filtration, washed with 300 g of methanol and 300 g of diisopropyl ether in this order, and collected. The collected crystal was vacuum-dried at 70°C to obtain a polymer (A3).

The weight-average molecular weight (Mw) and the dispersity (Mw/Mn) were determined by GPC, and the following results were obtained.
(A3): Mw=560, Mw/Mn=2.43

### [Synthesis Example 4] Synthesis of Polymer (A4)

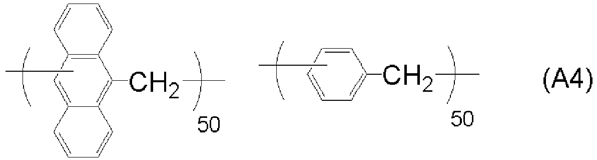

Under a nitrogen atmosphere, 30.0 g of the compound (b3), 15.6 g of the compound (b1), and 230 g of 1,2-dichloroethane were mixed together and then homogeneously dispersed at an internal temperature of 60°C. To the obtained mixture, 55.4 g of methanesulfonic acid was added dropwise over 1 hour, and the mixture was heated and stirred at an internal temperature of 70°C for 6 hours. After cooling the mixture to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 120 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain a polymer (A4).

The weight-average molecular weight (Mw) and the dispersity (Mw/Mn) were determined by GPC, and the following results were obtained.
(A4): Mw=680, Mw/Mn=2.27

### [Synthesis Example 5] Synthesis of Polymer (A5)

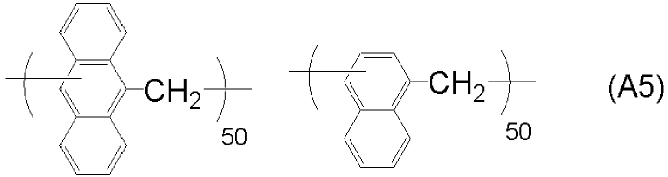

Under a nitrogen atmosphere, 30.0 g of the compound (b3), 22.8 g of the compound (b4), and 260 g of 1,2-dichloroethane were mixed together and then homogeneously dispersed at an internal temperature of 60°C. To the obtained mixture, 55.4 g of methanesulfonic acid was added dropwise over 1 hour, and the mixture was heated and stirred at an internal temperature of 70°C for 6 hours. After cooling the mixture to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 120 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain a polymer (A5).

The weight-average molecular weight (Mw) and the dispersity (Mw/Mn) were determined by GPC, and the following results were obtained.
(A5): Mw=720, Mw/Mn=2.13

### [Synthesis Example 6] Synthesis of Polymer (A6)

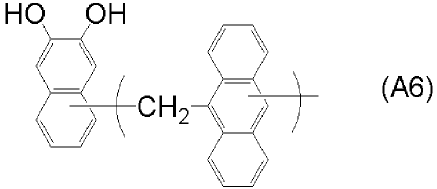

Under a nitrogen atmosphere, 60.0 g of the compound (b3), 4.6 g of the compound (b5), and 325 g of 1,2-dichloroethane were mixed together and then homogeneously dispersed at an internal temperature of 60°C. To the obtained mixture, 55.4 g of methanesulfonic acid was added dropwise over 1 hour, and the mixture was heated and stirred at an internal temperature of 70°C for 6 hours. After cooling the mixture to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 200 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain a polymer (A6).

The weight-average molecular weight (Mw) and the dispersity (Mw/Mn) were determined by GPC, and the following results were obtained.
(A6): Mw=700, Mw/Mn=1.43

### [Synthesis Example 7] Synthesis of Polymer (A7)

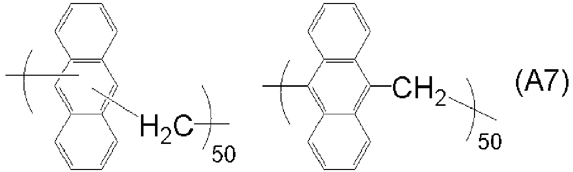

Under a nitrogen atmosphere, 30.0 g of anthracene, 46.3 g of the compound (c6), and 300 g of 1,2-dichloroethane were mixed together and then homogeneously dispersed at an internal temperature of 60°C. Subsequently, 55.0 g of methanesulfonic acid was added dropwise over 1 hour, and the mixture was heated and stirred at an internal temperature of 70°C for 24 hours. After cooling the mixture to room temperature, 400 g of 1,2-dichloroethane was added thereto, and then insoluble matter was removed by filtration. The collected filtrate was washed six times with 200 g of ultrapure water, and the organic layer was evaporated under reduced pressure to dryness. After adding 150 g of THF to the residue to yield a homogeneous solution, a crystal was precipitated in 500 g of diisopropyl ether. The precipitated crystal was separated by filtration, washed twice with 300 g of diisopropyl ether, and collected. The collected crystal was vacuum-dried at 70°C to obtain a polymer (A7).

The weight-average molecular weight (Mw) and the dispersity (Mw/Mn) were determined by GPC, and the following results were obtained.
(A7): Mw=942, Mw/Mn=2.73

### Comparative Synthesis Example: Synthesis of Comparative Polymer and Comparative Compound

To synthesize comparative polymers (R2), (R3), (R5), (R7), (R9), and (R11), the compound group c ((c1) to (c5)) shown below and the compound group b ((b2)) were used.

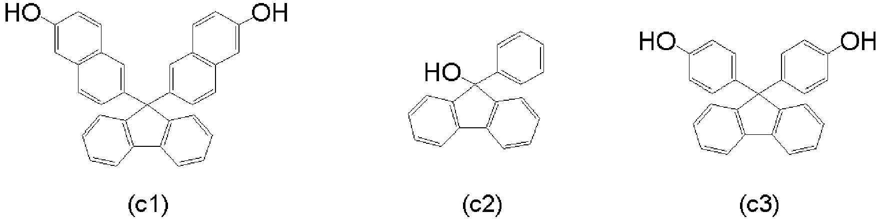

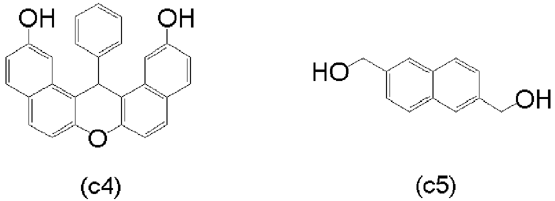

### [Comparative Synthesis Example 1] Synthesis of Comparative Polymer (R1)

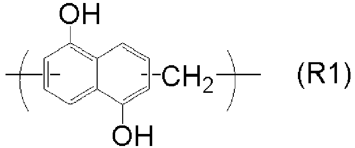

Under a nitrogen atmosphere, 160.2 g of 1,5-dihydroxynaphthalene, 64.9 g of a 37% formaldehyde solution, and 300 g of PGME (propylene glycol monomethyl ether) were mixed together and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the mixed solution was cooled to room temperature, 2,000 ml of methyl isobutyl ketone (MIBK) was added thereto, the product was washed six times with 500 ml of ultrapure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C to obtain a polymer (R1).

The weight-average molecular weight (Mw) and the dispersity (Mw/Mn) were determined by GPC, and the following results were obtained.
(R1): Mw=4,000, Mw/Mn=3.0

### [Comparative Synthesis Example 2] Synthesis of Comparative Polymer (R2)

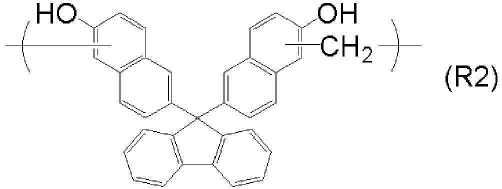

Under a nitrogen atmosphere, 90.1 g of the compound (c1), 9.7 g of a 37% formaldehyde solution, and 270 g of 2-methoxy-1-propanol were mixed together to form a homogeneous solution at a solution temperature of 80°C. Subsequently, 18 g of a 20% solution of p-toluenesulfonic acid in 2-methoxy-1-propanol was slowly added thereto, and the mixture was stirred at a solution temperature of 110°C for 8 hours. After the mixture was cooled to room temperature, 600 g of methyl isobutyl ketone was added thereto, the organic layer was washed five times with 200 g of ultrapure water, and then the organic layer was evaporated under reduced pressure to dryness. 320 g of THF was added to the residue, and the polymer was reprecipitate in 1,350 g of hexane. The precipitated polymer was separated by filtration and dried under reduced pressure to obtain a polymer (R2).

The weight-average molecular weight (Mw) and the dispersity (Mw/Mn) were determined by GPC, and the following results were obtained.
(R2): Mw=3,460, Mw/Mn=4.60

### [Comparative Synthesis Example 3] Synthesis of Comparative Polymer (R3)

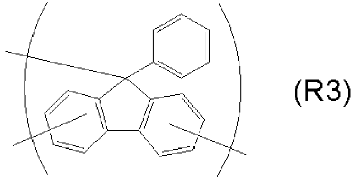

The polymer reported in [Synthesis Example 1] of JP2021-138851A was synthesized. 54.5 g of fluorenol (c2) and 200 g of 1,2-dichloroethane were mixed together and the temperature was raised to 50°C. 20.3 g of methanesulfonic acid was slowly added dropwise, and the mixture was heated and stirred at 70°C for 6 hours. After cooling the mixture to room temperature, 650 g of toluene was added, the product was washed six times with 100 g of ultrapure water, and the organic layer was evaporated under reduced pressure to dryness. After adding 200 g of THF to the residue to yield a homogeneous solution, a crystal was precipitated in 600 g of methanol. The precipitated crystal was separated by filtration, washed twice with 200 g of methanol, and collected. The collected crystal was vacuum-dried at 70°C to obtain a polymer (R3).

The weight-average molecular weight (Mw) and the dispersity (Mw/Mn) were determined by GPC, and the following results were obtained.
(R3): Mw=2,700, Mw/Mn=1.39

### [Comparative Synthesis Example 4] Synthesis of Comparative Compound (R4)

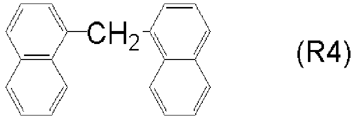

Under a nitrogen atmosphere, 20.0 g of di-1-naphthylmethanol and 240 ml of dichloroethane were mixed together and homogenized at room temperature, and then 11.6 g of triethylsilane and 2.9 g of methanesulfonic acid were added thereto. After stirring the mixture for 5 minutes to form a homogeneous solution, a reaction was allowed to take place in an oil bath at 60°C for 3 hours. The mixture was cooled to room temperature, and 100 ml of ultrapure water was added slowly to quench the reaction. The solution was transferred to a separating funnel, the organic phase in the lower layer was collected and further washed five times with ultrapure water, and then the organic layer was evaporated under reduced pressure to dryness to collect a compound (R4).

The weight-average molecular weight (Mw) and the dispersity (Mw/Mn) were determined by GPC, and the following results were obtained.
(R4): Mw=280, Mw/Mn=1.01

### [Comparative Synthesis Example 5] Synthesis of Comparative Polymer (R5)

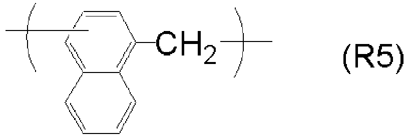

Under a nitrogen atmosphere, 60.0 g of the compound (b2) and 300 g of 1,2-dichloroethane were mixed together and then homogeneously dispersed at an internal temperature of 60°C. Subsequently, 74.5 g of methanesulfonic acid was added dropwise over 1 hour, and the mixture was heated and stirred at an internal temperature of 70°C for 6 hours. After cooling the mixture to room temperature, 400 g of 1,2-dichloroethane was added thereto, and then insoluble matter was removed by filtration. The collected filtrate was washed six times with 200 g of pure water, and the organic layer was evaporated under reduced pressure to dryness. After adding 200 g of THF to the residue to yield a homogeneous solution, a crystal was precipitated in 600 g of methanol. The precipitated crystal was separated by filtration, washed twice with 400 g of methanol, and collected. The collected crystal was vacuum-dried at 70°C to obtain a polymer (R5).

The weight-average molecular weight (Mw) and the dispersity (Mw/Mn) were determined by GPC, and the following results were obtained.
(R5): Mw=3,150, Mw/Mn=1.43

### [Comparative Synthesis Example 6] Synthesis of Comparative Polymer (R6)

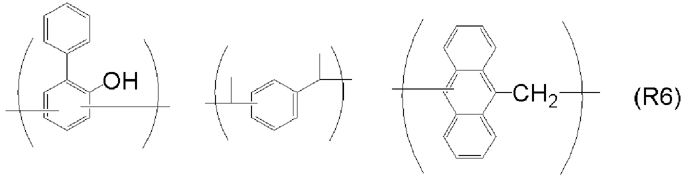

Under a nitrogen atmosphere, 15.6 g of 2-phenylphenol, 19.1 g of 9-anthracene methanol, 12.3 g of divinylbenzene, 30 g of cyclopentyl methyl ether (CPME), and 110 g of diethylene glycol dimethyl ether were mixed together and stirred at room temperature to form a homogeneous dispersion. After that, 1.14 g of trifluorosulfonic acid was slowly added thereto, and the mixture was further stirred for 5 minutes to form a homogeneous solution. Then, a reaction was allowed to take place for 4 hours while removing generated water from the reaction system in an oil bath at 140°C. The reaction product was cooled to room temperature, diluted with 250 g of CPME, transferred to a separating funnel, and washed four times with ultrapure water. Then, the organic layer was evaporated under reduced pressure to dryness. 120 g of CPME was added to the residue, and a polymer was precipitated in 500 g of hexane. The precipitated crystal was separated by filtration, washed twice with 200 g of hexane, and collected. The collected crystal was vacuum-dried at 70°C to obtain a polymer (R6).

The weight-average molecular weight (Mw) and the dispersity (Mw/Mn) were determined by GPC, and the following results were obtained.
(R6): Mw=1,960, Mw/Mn=1.57

### [Comparative Synthesis Example 7] Synthesis of Comparative Polymer (R7)

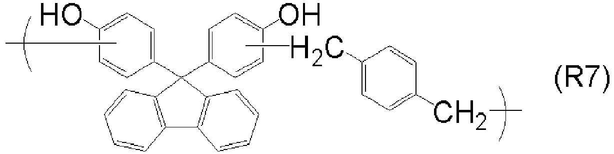

Under a nitrogen atmosphere, 38.0 g of the compound (c3), 17.0 g of 1,4-bis(methoxymethyl)benzene, 0.5 g of diethyl sulfate, and 82 g of propylene glycol monomethyl ether acetate (PGMEA) were mixed together and stirred at 100°C for 2 to 15 hours to allow a polymerization reaction to take place. The reaction product was gradually cooled at normal temperature. Subsequently, the reaction product was placed in 40 g of ultrapure water and 400 g of methanol, stirred hard, and then left to stand. The supernatant liquid was removed and the precipitate was dissolved in 80 g of propylene glycol monomethyl ether acetate (PGMEA). After that, the solution was stirred hard with 320 g of methanol and 320 g of ultrapure water, and then left to stand (primary step). The supernatant liquid obtained in this event was removed once more, and the precipitate was dissolved in 80 g of propylene glycol monomethyl ether acetate (PGMEA) (secondary step). To refer to the primary and secondary steps as one purification process, the purification process was performed a total of three times. After the purification was completed and the polymer was dissolved in 80 g of propylene glycol monomethyl ether acetate (PGMEA), the remaining methanol and ultrapure water were removed under reduced pressure to obtain a polymer (R7).

The weight-average molecular weight (Mw) and the dispersity (Mw/Mn) were determined by GPC, and the following results were obtained.
(R7): Mw=3,500, Mw/Mn=1.52

### [Comparative Synthesis Example 8] Synthesis of Comparative Polymer (R8)

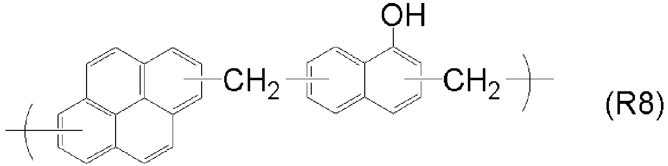

Under a nitrogen atmosphere, 28.3 g of pyrene, 28.8 g of 1-naphthol, 12.1 g of p-formaldehyde, 0.57 g of p-toluenesulfonic acid monohydrate, and 1,000 g of propylene glycol monomethyl ether acetate (PGMEA) were mixed together and stirred at room temperature for 17.5 hours to allow a polymerization reaction to take place. The reaction product was gradually cooled at normal temperature. Subsequently, the reaction product was placed in 40 g of ultrapure water and 400 g of methanol, stirred hard, and then left to stand. The supernatant liquid was removed and the precipitate was dissolved in 80 g of propylene glycol monomethyl ether acetate (PGMEA). After that, the solution was stirred hard with 320 g of methanol, and then left to stand (primary step). The supernatant liquid obtained in this event was removed once more, and the precipitate was dissolved in 80 g of propylene glycol monomethyl ether acetate (PGMEA) (secondary step). To refer to the primary and secondary steps as one purification process, the purification process was performed a total of three times. After the purification was completed and the polymer was dissolved in 80 g of propylene glycol monomethyl ether acetate (PGMEA), the remaining methanol and ultrapure water were removed under reduced pressure to obtain a polymer (R8).

The weight-average molecular weight (Mw) and the dispersity (Mw/Mn) were determined by GPC, and the following results were obtained.
(R8): Mw=4,000, Mw/Mn=1.75

### [Comparative Synthesis Example 9] Synthesis of Comparative Polymer (R9)

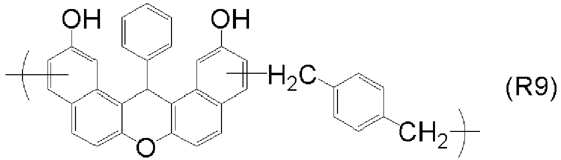

Under a nitrogen atmosphere, 5.0 g of the compound (c4), 2.1 g of 1,4-bis(methoxymethyl)benzene, 0.1 g of diethyl sulfate, and 15 g of propylene glycol monomethyl ether acetate (PGMEA) were mixed together and stirred at 100°C for 24 hours to allow a polymerization reaction to take place. The reaction product was precipitated in methanol, and monomers and low molecular weight compounds were removed to obtain a polymer (R9).

The weight-average molecular weight (Mw) and the dispersity (Mw/Mn) were determined by GPC, and the following results were obtained.
(R9): Mw=2,500, Mw/Mn=2.1

### [Comparative Synthesis Example 10] Synthesis of Comparative Polymer (R10)

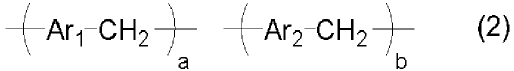

Under a nitrogen atmosphere, 3.5 g of indole, 6.0 g of pyrene, 1.8 g of p-formaldehyde, 0.57 g of p-toluenesulfonic acid monohydrate, and 100 g of propylene glycol monomethyl ether acetate (PGMEA) were mixed together and stirred at 90°C for 12 hours to allow a polymerization reaction to take place. The reaction product was gradually cooled at normal temperature. Subsequently, the reaction product was placed in 300 g of pure water and 300 g of methanol, stirred hard, and then left to stand. The supernatant liquid was removed and the precipitate was dissolved in 100 g of propylene glycol monomethyl ether acetate (PGMEA). After that, the solution was stirred hard with 300 g of methanol and 300 g of ultrapure water, and then left to stand (primary step). The supernatant liquid obtained in this event was removed once more, and the precipitate was dissolved in 80 g of propylene glycol monomethyl ether acetate (PGMEA) (secondary step). To refer to the primary and secondary steps as one purification process, the purification process was performed a total of three times. After the purification was completed and the polymer was dissolved in 80 g of propylene glycol monomethyl ether acetate (PGMEA), the remaining methanol and ultrapure water were removed under reduced pressure to obtain a polymer (R10).

The weight-average molecular weight (Mw) and the dispersity (Mw/Mn) were determined by GPC, and the following results were obtained.
(R10): Mw=2,800, Mw/Mn=1.51

### [Comparative Synthesis Example 11] Synthesis of Comparative Polymer (R11)

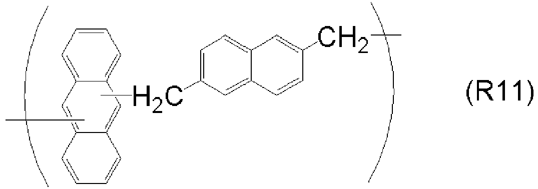

Under a nitrogen atmosphere, 30.0 g of anthracene, 22.2 g of the compound (c5), and 300 g of 1,2-dichloroethane were mixed together and then homogeneously dispersed at an internal temperature of 60°C. Subsequently, 55.0 g of methanesulfonic acid was added dropwise over 1 hour, and the mixture was heated and stirred at an internal temperature of 70°C for 24 hours. After cooling the mixture to room temperature, 400 g of 1,2-dichloroethane was added thereto, and then insoluble matter was removed by filtration. The collected filtrate was washed six times with 200 g of ultrapure water, and the organic layer was evaporated under reduced pressure to dryness. After adding 150 g of THF to the residue to yield a homogeneous solution, a crystal was precipitated in 500 g of diisopropyl ether. The precipitated crystal was separated by filtration, washed twice with 300 g of diisopropyl ether, and collected. The collected crystal was vacuum-dried at 70°C to obtain a polymer (R11).

The weight-average molecular weight (Mw) and the dispersity (Mw/Mn) were determined by GPC, and the following results were obtained.
(R11): Mw=2,480, Mw/Mn=1.93

### [Example 1 and Comparative Example 1: Solubility Evaluation]

The solubility of each of the polymers (A) ((A1) to (A7)) and the comparative polymers (R1) to (R11) synthesized above was determined.

As the solvent, two organic solvents, propylene glycol monomethyl ether acetate (PGMEA) and cyclohexanone (CyHO), were used, and a solubility evaluation was performed under each of three conditions: at a ratio of 70/30; at a ratio of 50/50; and using only CyHO. When the polymer was dissolved completely to form a homogeneous solution, the polymer was evaluated as "soluble", and when the polymer was not completely dissolved and an insoluble product was present, the polymer was evaluated as "insoluble".

The results are shown in Table 1 below.

**[Table 1]**

| Example 1 and Comparative Example 1 | Polymer | Solubility | | |
|---|---|---|---|---|
| | | PGMEA/CyHO =70/30 | PGMEA/CyHO =50/50 | Only CyHO |
| Example 1-1 | A1 | Soluble | Soluble | Soluble |
| Example 1-2 | A2 | Insoluble | Soluble | Soluble |
| Example 1-3 | A3 | Insoluble | Soluble | Soluble |
| Example 1-4 | A4 | Soluble | Soluble | Soluble |
| Example 1-5 | A5 | Soluble | Soluble | Soluble |
| Example 1-6 | A6 | Soluble | Soluble | Soluble |
| Example 1-7 | A7 | Insoluble | Insoluble | Soluble |
| Comparative Example 1-1 | R1 | Soluble | Soluble | Soluble |
| Comparative Example 1-2 | R2 | Soluble | Soluble | Soluble |
| Comparative Example 1-3 | R3 | Soluble | Soluble | Soluble |
| Comparative Example 1-4 | R4 | Soluble | Soluble | Soluble |
| Comparative Example 1-5 | R5 | Insoluble | Insoluble | Insoluble |
| Comparative Example 1-6 | R6 | Soluble | Soluble | Soluble |
| Comparative Example 1-7 | R7 | Soluble | Soluble | Soluble |
| Comparative Example 1-8 | R8 | Soluble | Soluble | Soluble |
| Comparative Example 1-9 | R9 | Soluble | Soluble | Soluble |
| Comparative Example 1-10 | R10 | Soluble | Soluble | Soluble |
| Comparative Example 1-11 | R11 | Insoluble | Insoluble | Insoluble |

In Examples 1-1 to 1-6, where the polymers to be used in inventive compositions for forming a resist underlayer film were used, excellent solubility was exhibited regarding the mixed solvent of PGMEA/CyHO=50/50 and CyHO. To compare Examples 1-1 to 1-3, among the polymers of the present invention, there was a tendency that the larger the structure of the condensed aromatic ring, the less soluble the polymer, but the polymers (A1) to (A6), including the polymers (A2) and (A3), were soluble in the mixed solvent of PGMEA/CyHO=50/50 and the solvent of CyHO. Basically, CyHO has a better ability of dissolving resin, but from the viewpoint of film-formability, a larger amount of PGMEA is preferably contained.

Out of the polymers to be contained in inventive compositions for forming a resist underlayer film, the polymer of Example 1-7 alone did not dissolve in the PGMEA/CyHO system. This polymer is a resin having a similar structure to the polymer (A3) in that the aromatic group represented by Ar in the general formula (1) is anthracene, but was synthesized by a different synthesis method, alternative method 2, and it is conjectured that the polymer did not dissolve because it was difficult to control the molecular weight by the synthesis according to the alternative method 2, so that the molecular weight was greater than that of the polymer (A3).

On the other hand, in Comparative Example 1-5, where the comparative polymer (R5), having a higher molecular weight than the polymers to be used in inventive compositions for forming a resist underlayer film, was used, solubility in CyHO was insufficient. It can be seen from this fact that molecular weight control is important for achieving excellent solvent solubility.

Meanwhile, in Comparative Example 1-11, where the comparative polymer (R11) was used, the polymer being a block copolymer including, as a repeating unit, a unit containing an aromatic group having a substituent unlike the polymers to be used in inventive compositions for forming a resist underlayer film, solubility was insufficient regarding all the solvents used for the above-described solubulity evaluation.

The polymers (A4) and (A5), which are polymers to be used in inventive compositions for forming a resist underlayer film, are random polymers, and were successfully dissolved in each of the mixed solvent of PGMEA/CyHO=70/30, the mixed solvent of PGMEA/CyHO=50/50, and CyHO. It can be seen from this that the polymers to be contained in inventive compositions for forming a resist underlayer film had better solvent solubility.

In Examples 1-4 to 1-6, where the polymers (A4) and (A5), each being a copolymer having two kinds of repeating units, and the polymer (A6), being end-capped with 2,3-naphthol, were used, improvement in solubility in the mixed solvent of PGMEA/CyHO=70/30 was achieved compared to Example 1-3, where the polymer (A3) was used.

### Preparation of Compositions for Forming Resist Underlayer Film

Compositions for forming a resist underlayer film were prepared using each of the polymers (A1) to (A7) and comparative polymers (R1) to (R4) and (R6) to (R10), which were excellent in the above-described solubility evaluation, according to the following procedure.

### [Preparation of Composition UDL-1 for Forming Resist Underlayer Film]

The polymer (A1) was dissolved at a ratio shown in Table 3 in a mixed solvent of propylene glycol monomethyl ether acetate (PGMEA) and cyclohexanone (CyHO) containing 0.5 mass% of a surfactant FC-4430 (available from Sumitomo 3M Limited). The obtained solution was filtered through a 0.02-µm membrane filter to prepare a composition (UDL-1) for forming a resist underlayer film.

### [Preparation of Compositions (UDL-2 to -12) for Forming Resist Underlayer Film and Comparative Compositions (Comparative UDL-1 to -9) for Forming Resist Underlayer Film]

Each of compositions for forming a resist underlayer film was prepared in the same manner as the composition UDL-1 for forming a resist underlayer film, except that the kind and the contained amount of each component were as shown in Table 3. Note that in Table 3, "-" indicates that the component was not used. As a blend resin, a resin represented by one of the following formulae (C1) to (C3) was used, as a crosslinking agent, a compound represented by the following formula (D1) was used, as an acid generator (TAG), a compound represented by the following formula (G1) was used, and as a flowability accelerator, a compound represented by the following formula (E1) was used.

### [Blend Resin]

The blend resins (C1) to (C3) used in the compositions UDL-8 to UDL-10 for forming a resist underlayer film are shown below.

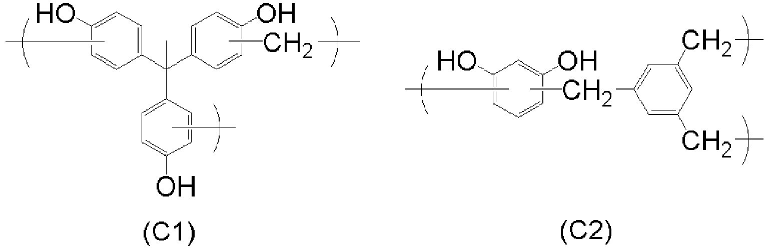

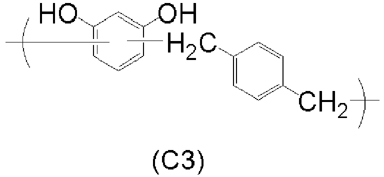

### [Crosslinking Agent]

The crosslinking agent (D1) used in the composition UDL-11 for forming a resist underlayer film is shown below.

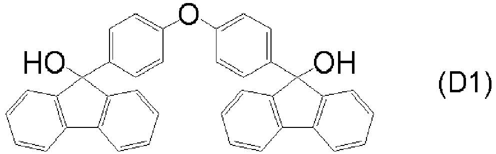

### [Acid Generator]

The thermal acid generator (G1) used in the composition UDL-11 for forming a resist underlayer film is shown below.

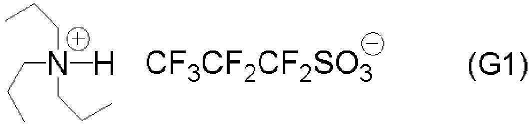

### [Flowability Accelerator]

The flowability accelerator (E1) used in the composition UDL-12 for forming a resist underlayer film is shown below.

**[Table 2]**

| Compound or polymer | Mw (calculated value) | Weight reduction rate on heating from 30°C to 190°C | Weight reduction rate on heating from 30°C to 350°C |
|---|---|---|---|
| 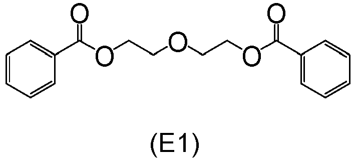 | 314 | 1 | 100 |

**[Table 3]**

| Composition for forming resist underlayer film | Polymer | Crosslinking agent | Additive | Solvent |
|---|---|---|---|---|
| | (parts by mass) | (parts by mass) | (parts by mass) | (parts by mass) |
| UDL-1 | A1 (12) | - | - | PGMEA/CyHO (70/30) |
| UDL-2 | A2 (12) | - | - | PGMEA/CyHO (50/50) |
| UDL-3 | A3 (12) | - | - | PGMEA/CyHO (50/50) |
| UDL-4 | A4 (12) | - | - | PGMEA/CyHO (70/30) |
| UDL-5 | A5 (12) | - | - | PGMEA/CyHO (70/30) |
| UDL-6 | A6 (12) | - | - | PGMEA/CyHO (70/30) |
| UDL-7 | A7 (12) | - | - | CyHO (100) |
| UDL-8 | A3 (12) | - | C1 (6) | PGMEA/CyHO (50/50) |
| UDL-9 | A3 (12) | - | C2 (6) | PGMEA/CyHO (50/50) |
| UDL-10 | A3 (12) | - | C3 (6) | PGMEA/CyHO (50/50) |
| UDL-11 | A3 (12) | D1 (3) | G1 (0.2) | PGMEA/CyHO (50/50) |
| UDL-12 | A3 (12) | - | E1 (6) | PGMEA/CyHO (50/50) |
| Comparative UDL-1 | R1 (12) | - | - | PGMEA/CyHO (70/30) |
| Comparative UDL-2 | R2 (12) | - | - | PGMEA/CyHO (70/30) |
| Comparative UDL-3 | R3 (12) | - | - | PGMEA/CyHO (70/30) |
| Comparative UDL-4 | R4 (12) | - | - | PGMEA/CyHO (70/30) |
| Comparative UDL-5 | R6 (12) | - | - | PGMEA/CyHO (70/30) |
| Comparative UDL-6 | R7 (12) | - | - | PGMEA/CyHO (70/30) |
| Comparative UDL-7 | R8 (12) | - | - | PGMEA/CyHO (70/30) |
| Comparative UDL-8 | R9 (12) | - | - | PGMEA/CyHO (70/30) |
| Comparative UDL-9 | R10 (12) | - | - | PGMEA/CyHO (70/30) |

### [Example 2 and Comparative Example 2: Solvent Resistance Evaluation and Film Thickness Uniformity Evaluation on High-Temperature Treatment under Nitrogen Atmosphere]

Each of the above-described compositions (UDL-1 to -12 and comparative UDL-1 to -9) for forming a resist underlayer film was respectively applied onto a silicon substrate, and baked at 350°C for 60 seconds, then baked under a nitrogen atmosphere controlled to have an oxygen concentration of 0.2% or less at 550°C for 90 seconds, the film thickness from the central portion to the peripheral portion of the substrate was measured, and the average film thickness (a [nm]) was calculated therefrom. Subsequently, a PGMEA solvent was dispensed thereon, left to stand for 30 seconds, spin-dried, baked at 100°C for 60 seconds to evaporate the PGMEA, and the film thickness (b [nm]) was measured. The difference in the film thicknesses (film remaining percentage: (b/a)×100) before and after the PGMEA treatment was determined.

In addition, regarding films each obtained by baking under a nitrogen atmosphere controlled to have an oxygen concentration of 0.2% or less at 550°C for 90 seconds, the film thickness from the central portion to the peripheral portion of the substrate was measured. When the film thickness difference between the maximum film thickness and the minimum film thickness out of the measured values was less than 4% of the average film thickness (a), the composition was evaluated as "very good", when 4 to 8%, "good", and when 8% or more, "poor".

The results are shown in Table 4 below.

**[Table 4]**

| Example 2 and Comparative Example 2 | Composition for forming resist underlayer film | Film thickness (a) | After PGMEA treatment (b) | Film remaining percentage | Film thickness uniformity |
|---|---|---|---|---|---|
| | | nm | nm | b/a× 100 (%) | |
| Example 2-1 | UDL-1 | 79.9 | 79.8 | 100% | Good |
| Example 2-2 | UDL-2 | 81.1 | 81.1 | 100% | Good |
| Example 2-3 | UDL-3 | 80.1 | 79.9 | 100% | Good |
| Example 2-4 | UDL-4 | 81.5 | 81.4 | 100% | Good |
| Example 2-5 | UDL-5 | 82.4 | 82.4 | 100% | Good |
| Example 2-6 | UDL-6 | 84.0 | 84.1 | 100% | Good |
| Example 2-7 | UDL-7 | 82.2 | 82.2 | 100% | Good |
| Example 2-8 | UDL-8 | 81.2 | 81.0 | 100% | Very good |
| Example 2-9 | UDL-9 | 81.5 | 81.3 | 100% | Very good |
| Example 2-10 | UDL-10 | 80.9 | 80.8 | 100% | Very good |
| Example 2-11 | UDL-11 | 82.4 | 82.4 | 100% | Very good |
| Example 2-12 | UDL-12 | 80.2 | 80.0 | 100% | Good |
| Comparative Example 2-1 | Comparative UDL-1 | 87.2 | 86.9 | 100% | Good |
| Comparative Example 2-2 | Comparative UDL-2 | 95.3 | 95.2 | 100% | Very good |
| Comparative Example 2-3 | Comparative UDL-3 | 90.2 | 89.8 | 100% | Good |
| Comparative Example 2-4 | Comparative UDL-4 | 30.2 | 30.3 | 100% | Poor |
| Comparative Example 2-5 | Comparative UDL-5 | 60.5 | 60.7 | 100% | Poor |
| Comparative Example 2-6 | Comparative UDL-6 | 90.5 | 90.3 | 100% | Very good |
| Comparative Example 2-7 | Comparative UDL-7 | 89.9 | 89.5 | 100% | Very good |
| Comparative Example 2-8 | Comparative UDL-8 | 88.8 | 88.7 | 100% | Very good |
| Comparative Example 2-9 | Comparative UDL-9 | 90.2 | 90.1 | 100% | Very good |

As shown in Table 4, in Examples 2-1 to 2-12, where the inventive compositions (UDL-1 to -12) for forming a resist underlayer film were used, the film remaining percentage ((a/b)×100) after the PGMEA rinsing treatment was higher than 99%, and it can be seen that a crosslinking reaction took place, so that sufficient solvent resistance was exhibited.

In addition, in Examples 2-1 to 2-12, where the inventive compositions (UDL-1 to -12) for forming a resist underlayer film were used, the film thickness difference between the maximum film thickness and the minimum film thickness of the film baked under a nitrogen atmosphere at 550°C was less than 8% of the average film thickness (a), and it was observed that the film thickness uniformity was good. Furthermore, in Examples 2-8 to 2-11, where the blend resin (C) or the crosslinking agent (D) was contained, improvement in film thickness uniformity was observed, compared to Example 2-3, where these additives were not contained. On the other hand, in Comparative Example 2-4, where a resin having a low molecular weight was used, the amount of sublimation product at the time of high-temperature treatment was large, and therefore, the film thickness was much thinner than the others, and film thickness uniformity was also degraded. Meanwhile, in Comparative Example 2-5, it is conjectured that heat resistance was poor, and therefore thermal decomposition was severe and film thickness uniformity was degraded, possible because the polymer (R6), containing a repeating unit having a hydroxy group, was used.

### [Example 3 and Comparative Example 3: Evaluation of Filling Property and Flatness]

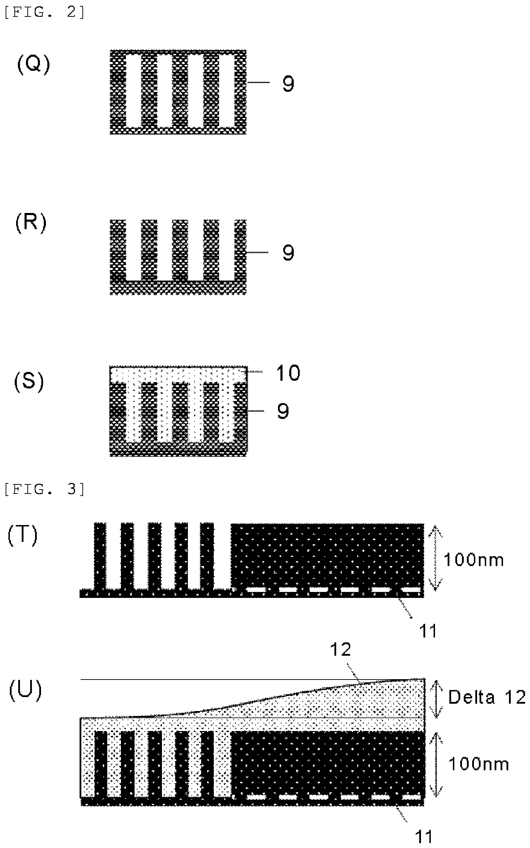

Filling property evaluation: each of the compositions (UDL-1 to -11 and comparative UDL-1 to -9) for forming a resist underlayer film was respectively applied onto an SiO₂ wafer substrate having a dense line-and-space pattern (line width = 60 nm, line depth = 100 nm, distance between the centers of two adjacent lines = 120 nm), baked by using a hot plate at 350°C for 60 seconds, and then baked under a nitrogen atmosphere controlled to have an oxygen concentration of 0.2% or less at 550°C for 90 seconds to form a resist underlayer film having a film thickness of 100 nm. The substrate used was a base substrate 9 (SiO₂ wafer substrate) having a dense line-and-space pattern shown in FIG. 2(Q) (downward view) and (R) (cross-sectional view).

The cross-sectional shape of each of the obtained wafer substrates was observed using an electron microscope (S-4700: manufactured by Hitachi, Ltd.), and the presence/absence of voids (gaps) inside the resist underlayer film filling the space between the lines was confirmed. Table 5 shows the results. In this evaluation, when a composition for forming a resist underlayer film having a poor filling property is used, voids are generated inside the resist underlayer film filling the space between the lines. In this evaluation, when a composition for forming a resist underlayer film having a desirable filling property is used, as shown in FIG. 2(S), the inside of the resist underlayer film filling the space between the lines of the base substrate 9 having the dense line-and-space pattern is filled with a void-free resist underlayer film 10.

Flatness evaluation: regarding base substrates 11 (SiO₂ wafer substrates) each having a dense line-and-space pattern as shown in FIG. 3(T), the cross sectional shape of each of the wafer substrates obtained in the above-described filling property evaluation as shown in FIG. 3(U) was observed using a scanning electron microscope (SEM), and the step Delta 12 between the line-pattern-dense portion and the non-line-pattern portion of the filling film 12 was observed using an electron microscope (S-4700: manufactured by Hitachi, Ltd.). In the present evaluation, it can be said that the smaller the step, the better the planarizing property. Table 5 shows the results.

**[Table 5]**

| Example 3 and Comparative Example 3 | Composition for forming resist underlayer film | Filling property | Flatness |
|---|---|---|---|
| | | Voids | nm |
| Example 3-1 | UDL-1 | Absent | 47 |
| Example 3-2 | UDL-2 | Absent | 48 |
| Example 3-3 | UDL-3 | Absent | 47 |
| Example 3-4 | UDL-4 | Absent | 49 |
| Example 3-5 | UDL-5 | Absent | 46 |
| Example 3-6 | UDL-6 | Absent | 45 |
| Example 3-7 | UDL-7 | Absent | 49 |
| Example 3-8 | UDL-8 | Absent | 47 |
| Example 3-9 | UDL-9 | Absent | 48 |
| Example 3-10 | UDL-10 | Absent | 48 |
| Example 3-11 | UDL-11 | Absent | 46 |
| Example 3-12 | UDL-12 | Absent | 42 |
| Comparative Example 3-1 | Comparative UDL-1 | Absent | 50 |
| Comparative Example 3-2 | Comparative UDL-2 | Absent | 52 |
| Comparative Example 3-3 | Comparative UDL-3 | Absent | 52 |
| Comparative Example 3-4 | Comparative UDL-4 | Present | 56 |
| Comparative Example 3-5 | Comparative UDL-5 | Present | 53 |
| Comparative Example 3-6 | Comparative UDL-6 | Absent | 48 |
| Comparative Example 3-7 | Comparative UDL-7 | Absent | 51 |
| Comparative Example 3-8 | Comparative UDL-8 | Absent | 50 |
| Comparative Example 3-9 | Comparative UDL-9 | Absent | 49 |

As shown in Table 5, it was successfully confirmed that in Examples 3-1 to 3-12, where the inventive compositions (UDL-1 to -12) for forming a resist underlayer film were used, it was possible to fill the dense line-and-space pattern without generating voids, and that the compositions had excellent filling property.

In addition, to compare Example 3-1 and Example 3-12, a better result was achieved in Example 3-12 regarding flatness. This is thought to be because thermal flowability was improved by the flowability accelerator (E1) being contained.

On the other hand, voids were generated in Comparative Example 3-4, where a COPNA resin, being a low molecular weight compound, was used, and in Comparative Example 3-5, where the polymer (R6), containing a repeating unit having a hydroxy group, was used. It is conjectured that voids induced by decomposition products were generated because these compositions both had considerably insufficient heat resistance.

### [Example 4 and Comparative Example 4: Etching Resistance Evaluation]

Each of the compositions (UDL-1 to -12 and comparative UDL-1 to -9) for forming a resist underlayer film was respectively applied onto a silicon substrate and the coating film was heated by using a hot plate at 350°C for 60 seconds to form a resist underlayer film (film baked at 350°C), and the film thickness "a" was measured. Subsequently, etching was performed with CF₄ gas under the following conditions by using an etching apparatus Telius manufactured by Tokyo Electron Ltd., and the film thickness "b" was measured. Then, the film thickness etched in 1 minute by using each gas was calculated as an etching rate A (nm/min) from the film thickness etched (film thickness "a" - film thickness "b") in the specified time.

In addition, separately from the above, each of the compositions (UDL-1 to -12 and comparative UDL-1 to -9) for forming a resist underlayer film was respectively applied onto a silicon substrate, and the coating film was heated by using a hot plate at 350°C for 60 seconds to prepare a substrate. The substrate was baked under a nitrogen atmosphere controlled to have an oxygen concentration of 0.2% or less at 450°C or 550°C for 90 seconds to form a resist underlayer film (film baked at high temperature), and the film thickness "c" was measured. Subsequently, etching was performed with CF₄ gas under the following conditions by using an etching apparatus Telius manufactured by Tokyo Electron Ltd., and the film thickness "d" was measured. Then, the film thickness etched in 1 minute by using each gas was calculated as an etching rate B (nm/min) from the film thickness etched (film thickness "c" - film thickness "d") in the specified time. The results are shown in Table 6 below.

The films baked at a high temperature of 450°C or 550°C and the films baked at 350°C were compared regarding etching resistance, and the etching resistance improvement effect (etching rate B (nm/min) - etching rate A (nm/min)) of the high-temperature baking at 450°C or 550°C was calculated. The results are shown in Table 6 below.

The etching conditions were as shown below.

Conditions of dry etching with CF₄ gas
Chamber pressure: 50 mT
RF-power (upper portion): 500 W
RF-power (lower portion): 300 W
CF₄ gas flow rate: 150 sccm
CHF₃ gas flow rate: 50 sccm
Time: 30 sec

**[Table 6]**

| Example | Composition for forming resist underlayer film | Temperature of high-temperature baking | Etching rate A (nm/min) | Etching rate B (nm/min) | Improvement (B-A) |
|---|---|---|---|---|---|
| | | | 350°C | Baking at 350°C and high temperature | nm/min |
| Example 4-1 | UDL-1 | 550°C | 70 | 55 | 15 |
| Example 4-2 | UDL-2 | 450°C | 67 | 57 | 10 |
| Example 4-3 | UDL-2 | 550°C | 67 | 53 | 14 |
| Example 4-4 | UDL-3 | 450°C | 65 | 54 | 11 |
| Example 4-5 | UDL-3 | 550°C | 65 | 50 | 15 |
| Example 4-6 | UDL-4 | 550°C | 67 | 52 | 15 |
| Example 4-7 | UDL-5 | 450°C | 66 | 56 | 10 |
| Example 4-8 | UDL-5 | 550°C | 66 | 52 | 14 |
| Example 4-9 | UDL-6 | 550°C | 68 | 52 | 16 |
| Example 4-10 | UDL-7 | 550°C | 69 | 54 | 15 |
| Example 4-11 | UDL-8 | 550°C | 67 | 54 | 13 |
| Example 4-12 | UDL-9 | 550°C | 67 | 52 | 15 |
| Example 4-13 | UDL-10 | 550°C | 68 | 53 | 15 |
| Example 4-14 | UDL-11 | 550°C | 69 | 55 | 14 |
| Example 4-15 | UDL-12 | 550°C | 66 | 52 | 14 |
| Comparative Example 4-1 | Comparative UDL-1 | 550°C | 105 | 98 | 7 |
| Comparative Example 4-2 | Comparative UDL-2 | 550°C | 73 | 71 | 2 |
| Comparative Example 4-3 | Comparative UDL-3 | 550°C | 70 | 67 | 3 |
| Comparative Example 4-4 | Comparative UDL-4 | 550°C | 66 | 51 | 15 |
| Comparative Example 4-5 | Comparative UDL-5 | 550°C | 72 | 65 | 7 |
| Comparative Example 4-6 | Comparative UDL-6 | 550°C | 73 | 69 | 4 |
| Comparative Example 4-7 | Comparative UDL-7 | 550°C | 72 | 70 | 2 |
| Comparative Example 4-8 | Comparative UDL-8 | 550°C | 75 | 71 | 4 |
| Comparative Example 4-9 | Comparative UDL-9 | 550°C | 72 | 68 | 4 |

As shown in Table 6, in Examples 4-1 to 4-15, where the inventive compositions (UDL-1 to -12) for forming a resist underlayer film were used, the rate of the etching of the film baked at 350°C by using CF₄ gas was 70 nm/min or lower, and it was shown that the compositions exhibit excellent etching resistance. Furthermore, the etching resistance of the film baked under a nitrogen atmosphere controlled to have an oxygen concentration of 0.2% or less at 450°C or 550°C was even better, and improvement in etching rate of 10 nm/min or more was observed compared to the film baked at 350°C. This is conjectured to be because the inventive compositions for forming a resist underlayer film are high-carbon materials that allow the cured film actively to undergo thermal decomposition by high-temperature baking, and therefore, when baking at 450°C or 550°C was carried out, decomposition and recombination of carbon bonds occurred, and the cured film was densified. Furthermore, in Examples 4-2 to 4-5 and Examples 4-7 and 4-8, densification was further promoted by raising the temperature of the high-temperature baking under a nitrogen atmosphere from 450°C to 550°C, and as a result, the high etching resistance was successfully improved.

Meanwhile, to compare Examples 4-1 to 4-5, there was a tendency that, among the polymers used in the inventive compositions for forming a resist underlayer film, the larger the condensed aromatic ring, the higher the etching resistance of the film, and out of the considered compositions, the compositions containing the polymer (A3), having the anthracene structure, exhibited the highest etching resistance.

Examples 4-6 to 4-8, where the random polymers (A4) and (A5), in which improvement in solvent solubility was observed, were used and Examples 4-11 to 4-14, where a blend resin or a crosslinking agent was added and improvement in film thickness uniformity on performing high-temperature treatment was observed, the etching resistance compared favorably in every case with that of Examples 4-4 and 4-5, where the polymer (A3) was used.

Compared to Example 4-10, where the polymer (A7), being a resin similar to the polymer (A3) in that the aromatic group represented by Ar in the general formula (1) is anthracene, was used, the polymer (A3) exhibited better etching resistance. The polymer (A7) was different from the polymer (A3) in the synthesis method, and was synthesized by the alternative method 2. Such a result is presumed to be because of difficulty in controlling the molecular weight when the polymer is synthesized by the alternative method 2, in the same manner as the results of the solubility, and this caused the polymer (A7) to have a greater molecular weight than the polymer (A3), resulting in difficulty in thermal decomposition. Accordingly, from these results, it can be seen that a composition containing a polymer synthesized by the alternative method 1 is preferable to a composition containing a polymer synthesized by the alternative method 2. On another aspect, it can be seen that when the Ar is anthracene, the polymer preferably has a molecular weight of 800 or less.

In Comparative Example 4-1, where the comparative polymer (R1), being a novolak resin having a methylene group like the polymers (resins) contained in the inventive compositions for forming a resist underlayer film, was used, the comparative polymer (R1), constituted by a repeating unit containing a hydroxy group, was used, and therefore, the oxygen amount in the resin itself was large and the etching resistance of the film baked at 350°C was insufficient, and etching resistance was also insufficient after the baking at 550°C. Meanwhile, in Comparative Example 4-2, where the comparative polymer (R2), also being a novolak resin and being comparatively high-carbon, was used, the etching resistance of the film baked at 350°C was comparatively good, but the improvement rate of the etching resistance after the baking at 550°C was low. This is presumed to be because the resin had high heat resistance, and high carbon and densification were difficult to achieve by high-temperature baking.

In Comparative Example 4-3, where the high-carbon and rigid comparative polymer (R3) was used, the result of the etching resistance of the film baked at 350°C was equivalent to that of the resins used in the Examples of the present invention and was good because the repeating unit of the comparative polymer (R3) does not have an oxygen atom. However, the repeating unit of the comparative polymer (R3) does not have a group for promoting thermal decomposition, such as a methylene group, and therefore, the improvement rate of the etching resistance after the high-temperature baking was also low regarding this resin.

In Comparative Example 4-4, where the comparative polymer (R4), having a similar structure to those of the resins of the present invention but having a low molecular weight, was used, the improvement rate of the etching resistance due to the high-temperature baking was similar to those of the products of the present invention, but the film thickness uniformity at the time of high-temperature baking, filling property, and flatness were insufficient, possibly because heat resistance was considerably insufficient, and it is difficult to apply the composition as a resist underlayer film.

In Comparative Example 4-5, where the comparative polymer (R6), having an aromatic group having a substituent as well as a COPNA resin component, was used, thermal decomposition was high, but the improvement degree of the etching resistance was smaller than those of the resins of the present invention. This is presumed to be because the proportion of the COPNA resin component, which easily forms an amorphous-carbon-like film by thermal decomposition, is small.

In addition, in Comparative Examples 4-6 to 9, where the comparative polymers (R7) to (R10), having structures comparatively close to those of the resins used in the Examples of the present invention, were used, the etching resistance of the film baked at 350°C was comparatively good, but the improvement rate of the etching resistance after the baking at 550°C was low. This is thought to be because, in the same manner as in the case of the above-described R2, heat resistance was increased by a repeating unit having a hydroxy group being contained, so that higher carbon and densification were difficult to achieve by the high-temperature baking.

Thus, it can be said that, to form a resist underlayer film excellent in etching resistance, a composition containing a polymer having a structure represented by the general formulae (1) to (3) is preferable.

### [Example 5 and Comparative Example 5: Patterning Process]

Each of the compositions (UDL-1 to -12 and comparative UDL-1 to 9) for forming a resist underlayer film was respectively applied onto a silicon wafer substrate on which was formed an SiO₂ film having a trench pattern (trench width: 10 um, trench depth: 0.10 µm), and the coating film was baked in the atmosphere at 350°C for 60 seconds. After that, the coating film was heated under a nitrogen atmosphere controlled to have an oxygen concentration of 0.2% or less at 550°C for 90 seconds to form a resist underlayer film having a film thickness of 100 nm. Subsequently, a silicon-containing resist middle layer film material (SOG-1) was applied onto the resist underlayer film, and the coating film was baked at 220°C for 60 seconds to form a resist middle layer film having a thickness of 20 nm. Subsequently, a monolayer resist for ArF as a resist upper layer film material was applied onto the resist middle layer film, and the coating film was baked at 105°C for 60 seconds to form a photoresist film having a thickness of 100 nm. Furthermore, a liquid immersion top coat composition (TC-1) was applied to the photoresist film, and the coating film was baked at 90°C for 60 seconds to form a top coat having a thickness of 50 nm.

The silicon-containing resist middle layer film material (SOG-1) was prepared in the following manner. A polymer represented by an ArF silicon-containing middle layer film polymer (SiP1) and a crosslinking catalyst (CAT1) were dissolved in an organic solvent containing 0.1 mass% of FC-4430 (manufactured by Sumitomo 3M Limited) in the proportion shown in Table 7. The obtained mixture was then filtered through a filter made of a fluororesin and having a pore size of 0.10 um to prepare the silicon-containing resist middle layer film material (SOG-1).

**[Table 7]**

| | Polymer (parts by mass) | Thermal crosslinking catalyst (parts by mass) | Solvent (parts by mass) |
|---|---|---|---|
| SOG-1 | SiP1 (100) | CAT1 (1.0) | PGMEA (4, 000) |

The structural formulae of the used ArF silicon-containing middle layer film polymer (SiP1) and crosslinking catalyst (CAT1) are shown below.

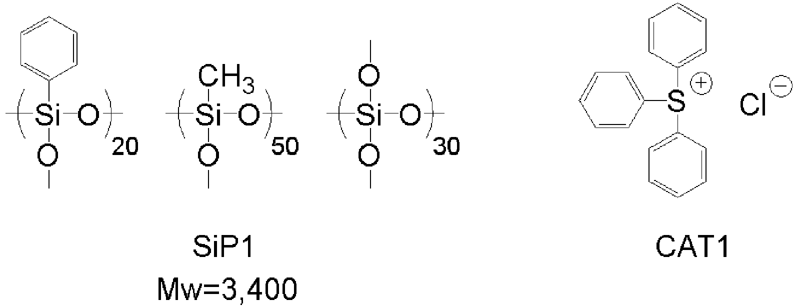

The resist upper layer film material (monolayer resist for ArF) was prepared by the following procedure. Firstly, a polymer (RP1), an acid generator (PAG1), and a basic compound (Amine1), were each dissolved in the proportion shown in Table 8, in a solvent containing 0.1% by mass of a surfactant (FC-4430: manufactured by Sumitomo 3M Limited). The obtained mixture was filtered through a 0.10-pm filter made of a fluororesin to obtain the resist upper layer film material.

**[Table 8]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

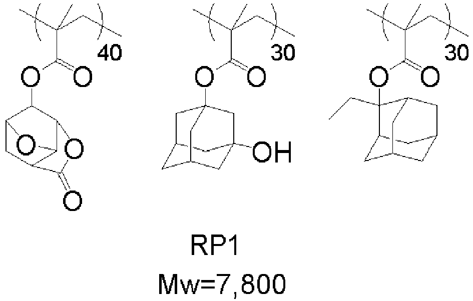

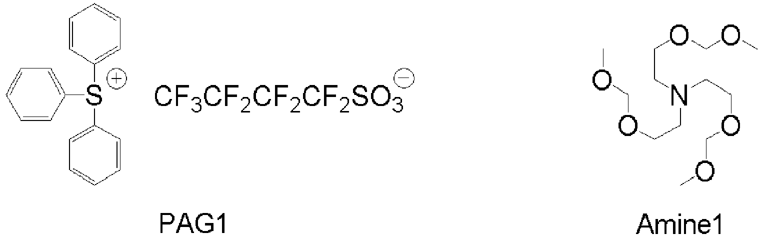

The liquid immersion top coat composition (TC-1) was prepared by the following procedure. Firstly, a top coat polymer (PP1) was dissolved in an organic solvent at the proportion shown in Table 9. The obtained mixture was filtered through a 0.10-pm filter made of a fluororesin to obtain the liquid immersion top coat composition.

**[Table 9]**

| | Polymer (parts by mass) | Solvent (parts by mass) |
|---|---|---|
| TC-1 | PP1 (100) | Diisoamyl ether (2,700) 2-methyl-1-butanol (270) |

The polymer (PP1) used for the liquid immersion top coat composition (TC-1) is shown below.

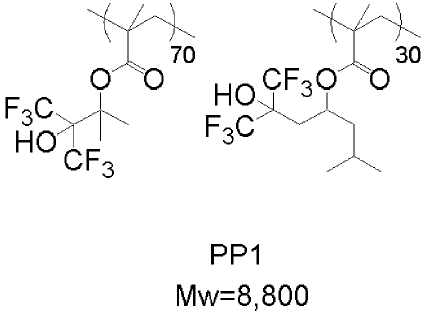

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass of aqueous tetramethylammonium hydroxide (TMAH) solution for 30 seconds, thereby obtaining a 55 nm 1:1 positive line-and-space pattern (resist pattern).

Subsequently, the silicon-containing resist middle layer film material (SOG-1) was etched by dry etching by using an etching apparatus Telius manufactured by Tokyo Electron Ltd. while using the resist pattern as a mask to form a hard mask pattern (SOG-1 pattern). Next, the resist underlayer film was etched while using the obtained SOG-1 pattern as a mask to form a resist underlayer film pattern. Then, the SiO₂ film was etched while using the obtained resist underlayer film pattern as a mask. The etching conditions were as follows.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 30 sec

### Conditions in transferring resist underlayer film pattern to SiO₂ film

Chamber pressure: 10 mT
RF-power (upper portion): 100 W
RF-power (lower portion): 800 W
CF₄ gas flow rate: 25 sccm
CHF₃ gas flow rate: 15 sccm
O₂ gas flow rate: 5 sccm
Time: 100 sec

The cross section of the pattern formed in the SiO₂ film was observed with an electron microscope (S-4700) manufactured by Hitachi, Ltd. Table 10 shows the results. "-" indicates that evaluation was not carried out due to film formation failure.

**[Table 10]**

| Example 5 and Comparative Example 5 | Composition for forming resist underlayer film | Pattern profile after etching for transferring pattern to substrate | CD after substrate processing | LWR after substrate processing |
|---|---|---|---|---|
| | | | nm | nm |
| Example 5-1 | UDL-1 | Vertical profile | 50.7 | 2.90 |
| Example 5-2 | UDL-2 | Vertical profile | 50.6 | 2.89 |
| Example 5-3 | UDL-3 | Vertical profile | 50.6 | 2.88 |
| Example 5-4 | UDL-4 | Vertical profile | 50.7 | 2.90 |
| Example 5-5 | UDL-5 | Vertical profile | 50.8 | 2.87 |
| Example 5-6 | UDL-6 | Vertical profile | 50.6 | 2.91 |
| Example 5-7 | UDL-7 | Vertical profile | 50.4 | 2.92 |
| Example 5-8 | UDL-8 | Vertical profile | 50.6 | 2.88 |
| Example 5-9 | UDL-9 | Vertical profile | 50.4 | 2.85 |
| Example 5-10 | UDL-10 | Vertical profile | 50.4 | 2.86 |
| Example 5-11 | UDL-11 | Vertical profile | 50.5 | 2.88 |
| Example 5-12 | UDL-12 | Vertical profile | 50.7 | 2.88 |
| Comparative Example 5-1 | Comparative UDL-1 | Vertical profile | 48.5 | 3.18 |
| Comparative Example 5-2 | Comparative UDL-2 | Vertical profile | 49.5 | 3.13 |
| Comparative Example 5-3 | Comparative UDL-3 | Vertical profile | 49.4 | 3.20 |
| Comparative Example 5-4 | Comparative UDL-4 | Pattern collapse | - | - |
| Comparative Example 5-5 | Comparative UDL-5 | Pattern collapse | - | - |
| Comparative Example 5-6 | Comparative UDL-6 | Vertical profile | 48.9 | 3.14 |
| Comparative Example 5-7 | Comparative UDL-7 | Vertical profile | 49.5 | 3.13 |
| Comparative Example 5-8 | Comparative UDL-8 | Vertical profile | 49.3 | 3.16 |
| Comparative Example 5-9 | Comparative UDL-9 | Vertical profile | 49.2 | 3.18 |

As shown in Table 10, in Examples 5-1 to 5-12, where the inventive compositions (UDL-1 to -12) for forming a resist underlayer film were used, the resist upper layer film pattern was desirably transferred to the SiO₂ film on the substrate in the end in every case. It was thus confirmed that the inventive composition for forming a resist underlayer film is suitably used for fine processing using the multilayer resist method. On the other hand, in Comparative Examples 5-1 to 5-3 and Comparative Examples 5-6 to 5-9, using comparative UDL-1 to -3 and comparative UDL-6 to -9, which were found to have insufficient etching resistance in the above-described etching resistance evaluation compared to the inventive compositions for forming a resist underlayer film, the pattern profile after the etching to transfer the pattern to the substrate was a vertical profile, but degradation in LWR was observed after the substrate processing. Meanwhile, in Comparative Examples 5-4 and 5-5, using compositions that had generated voids in the filling property evaluation, pattern collapse occurred.

It was thus revealed that the inventive composition for forming a resist underlayer film has both remarkably good dry-etching resistance and high filling and/or planarizing properties, and therefore, is significantly useful as a resist underlayer film material used in the multilayer resist method, and that the inventive patterning processes using this composition are capable of forming fine patterns with high accuracy even when a body to be processed is a substrate having a step.

The present description includes the following embodiments.
[1] A composition for forming a resist underlayer film, comprising:
   (A) a polymer having a structure represented by the following general formula (1) as a repeating unit; and
   (B) an organic solvent,
   wherein the polymer (A) has a molecular weight of 300 to 3,000, and the polymer (A) contains neither a repeating unit containing a hydroxy group as a substituent nor a repeating unit containing a heteroaromatic ring, 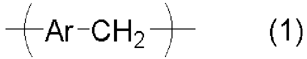 wherein Ar represents an unsubstituted divalent aromatic group having 6 to 30 carbon atoms.
[2] The composition for forming a resist underlayer film according to [1], wherein the aromatic group Ar has any of the following structures (1-a), 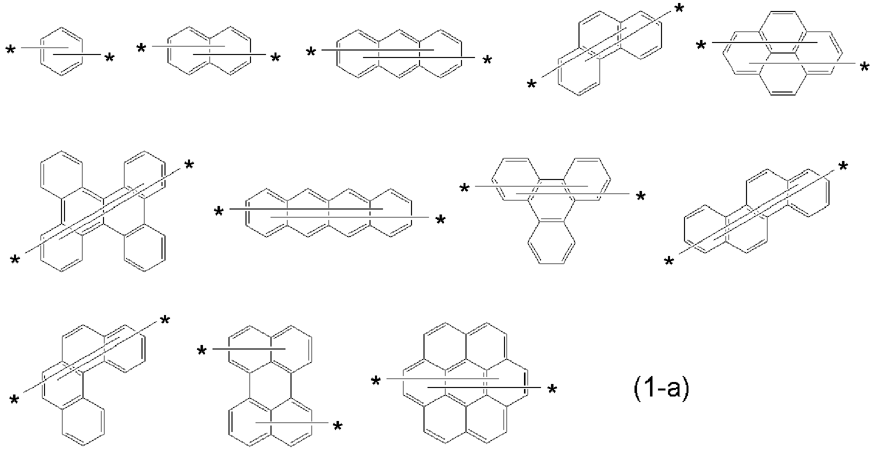 wherein "*" represents an attachment point to the methylene group in the general formula (1).
[3] The composition for forming a resist underlayer film according to [1] or [2], wherein the aromatic group Ar represents any of naphthalene, anthracene, phenanthrene, and pyrene.
[4] The composition for forming a resist underlayer film according to any one of [1] to [3], wherein the polymer (A) is a copolymer having two kinds of repeating units represented by the following general formulae (2), 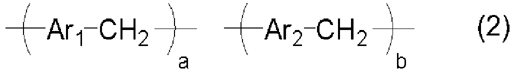 wherein Ar₁ represents any of naphthalene, anthracene, phenanthrene, and pyrene; Ar₂ has a structure different from that of Ar₁ and has any structure selected from the following formulae (1-a); and a+b is 100, 30 ≤ a ≤ 99, and 1 ≤ b ≤ 70. 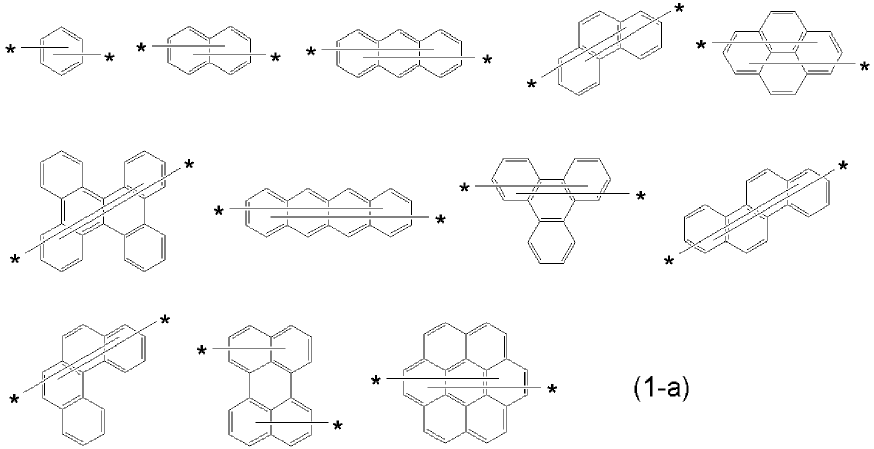
[5] The composition for forming a resist underlayer film according to [4], wherein the polymer (A), being the copolymer having two kinds of repeating units represented by the general formulae (2), is a polymerization reaction product of a monomer represented by the following formula (2-a) and a monomer represented by the following formula (2-b),

   **Ar₁-CH₂-X** **(2-a)**

   **Ar₂-CH₂-X** **(2-b)**

   wherein Ar₁ represents any of naphthalene, anthracene, phenanthrene, and pyrene; Ar₂ has a structure different from that of Ar₁ and has any structure selected from the formulae (1-a); and X represents a hydroxy group, an alkoxy group having 1 to 4 carbon atoms, or a halogen group.
[6] The composition for forming a resist underlayer film according to [5], wherein the Ar₁ in the formulae (2) is anthracene.
[7] The composition for forming a resist underlayer film according to any one of [1] to [6], wherein the polymer (A) has a molecular weight of 300 to 1,500.
[8] The composition for forming a resist underlayer film according to any one of [1] to [7], wherein the polymer (A) has an end-capping group represented by the following general formula (3), 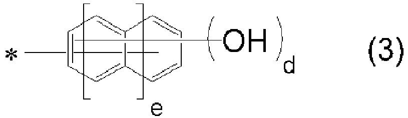 wherein "*" represents an attachment point to the methylene group in the formula (1); "d" represents an integer of 1 to 9; and "e" represents an integer of 0 to 2.
[9] The composition for forming a resist underlayer film according to any one of [1] to [8], further comprising (C) a blend resin, being a phenolic resin or a resin containing a phenolic hydroxy group.
[10] The composition for forming a resist underlayer film according to [9], wherein the blend resin (C) has a molecular weight of 4,000 to 12,000.
[11] The composition for forming a resist underlayer film according to [9] or [10], wherein the blend resin (C) is contained in an amount of 10 to 100 parts by mass based on 100 parts by mass of the polymer (A) .
[12] The composition for forming a resist underlayer film according to any one of [9] to [11], wherein the blend resin (C) is a resin represented by any of the following general formulae (C-1), (C-2), and (C-3), 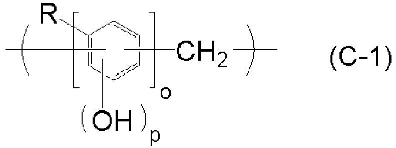 wherein R represents an organic group having a valency of 1 to 3, having 1 to 20 carbon atoms, and optionally containing an oxygen atom; "o" represents an integer of 1 to 3; and "p" represents an integer of 1 to 3, 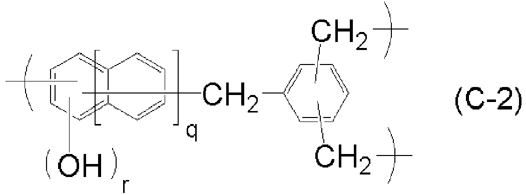 wherein "q" represents an integer of 0 or 1; and "r" represents an integer of 1 to 6, 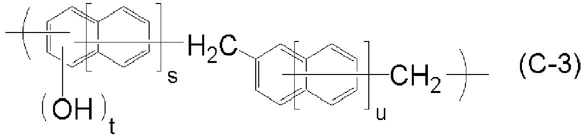 wherein "s" represents an integer of 0 or 1; "t" represents an integer of 1 to 6; and "u" represents an integer of 0 or 1.
[13] The composition for forming a resist underlayer film according to any one of [1] to [12], further comprising (D) a crosslinking agent having a structure represented by the following general formula (4), 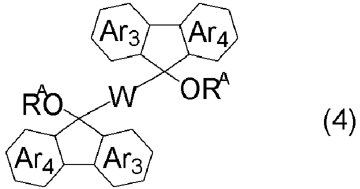 wherein Ar₃ and Ar₄ each represent a benzene ring or naphthalene ring optionally having a substituent; R^{A} represents a hydrogen atom or a monovalent organic group having 1 to 20 carbon atoms; W represents a group represented by any of the following general formulae (5), 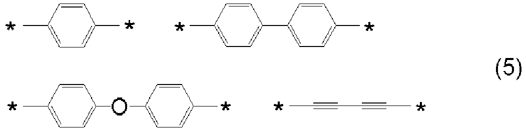 wherein "*" represents an attachment point.
[14] The composition for forming a resist underlayer film according to any one of [1] to [13], further comprising (E) a flowability accelerator having a weight reduction rate of less than 30% on heating from 30°C to 190°C and having a weight reduction rate of 98% or more on heating from 30°C to 350°C.
[15] The composition for forming a resist underlayer film according to [14], wherein the flowability accelerator (E) contains one or more compounds selected from the group consisting of compounds represented by the following general formulae (i) to (iii), 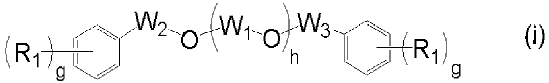 wherein each R₁ independently represents a hydrogen atom, a hydroxy group, or an organic group having 1 to 10 carbon atoms and optionally being substituted; W₁ represents a phenylene group or a divalent group represented by the following general formula (i-1); W₂ and W₃ each represent a single bond or a divalent group represented by either of the following general formulae (i-2); "g" represents an integer of 1 to 5; and "h" represents an integer of 0 to 10, 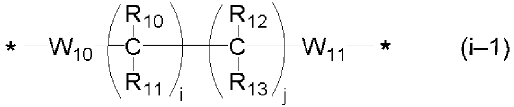 wherein "*" represents an attachment point; R₁₀, R₂₂, R₁₂, and R₁₃ each represent a hydrogen atom, a hydroxy group, or an organic group having 1 to 10 carbon atoms; W₁₀ and W₂₁ each independently represent a single bond or a carbonyl group; and "i" and "j" each represent an integer of 0 to 10, provided that i + j ≥ 1, 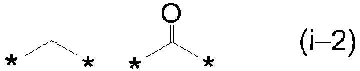 wherein "*" represents an attachment point, 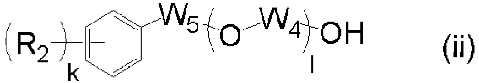 wherein each R₂ independently represents a hydrogen atom or an organic group having 1 to 10 carbon atoms and optionally being substituted; W₄ represents a divalent group represented by the following general formula (ii-1); W₅ represents a single bond or a divalent group represented by either of the following general formulae (ii-2); "k" represents an integer of 0 to 5; and "l" represents an integer of 2 to 10, 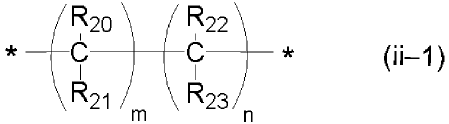 wherein "*" represents an attachment point; R₂₀, R₂₁, R₂₂, and R₂₃ each represent a hydrogen atom, a hydroxy group, or an organic group having 1 to 10 carbon atoms; and "m" and "n" each represent an integer of 0 to 10, provided that m + n ≥ 1, 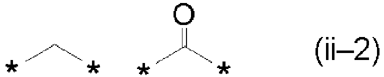 wherein "*" represents an attachment point, 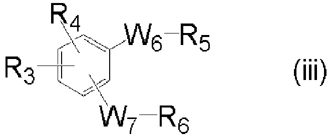 wherein R₃ and R₄ each represent a hydrogen atom, a hydroxy group, or an organic group having 1 to 10 carbon atoms, optionally being substituted, and optionally being bonded to each other to form a cyclic structure; R₅ and R₆ each represent an organic group having 1 to 10 carbon atoms, R₅ being a group containing either an aromatic ring or a divalent group represented by the following general formula (iii-1); and W₆ and W₇ each represent a single bond or a divalent group represented by either of the following general formulae (iii-2), at least one of W₆ and W₇ being a divalent group represented by either of the general formulae (iii-2), 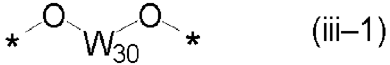 wherein "*" represents an attachment point; and W₃₀ represents an organic group having 1 to 4 carbon atoms, 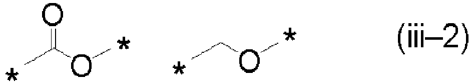 wherein "*" represents an attachment point.
[16] The composition for forming a resist underlayer film according to any one of [1] to [15], further comprising one or more of:
   (F) a surfactant;
   (G) an acid generator; and
   (H) a plasticizer.
[17] A patterning process for forming a pattern in a substrate to be processed, comprising the steps of:
   (I-1) applying the composition for forming a resist underlayer film according to any one of [1] to [16] onto a substrate to be processed to obtain a coating film, then heating the coating film to form a resist underlayer film;
   (I-2) forming a resist upper layer film on the resist underlayer film by using a photoresist material;
   (I-3) subjecting the resist upper layer film to pattern exposure and then to development with a developer to form a pattern in the resist upper layer film;
   (I-4) transferring the pattern to the resist underlayer film by dry etching while using the resist upper layer film having the formed pattern as a mask; and
   (I-5) processing the substrate to be processed while using the resist underlayer film having the formed pattern as a mask to form the pattern in the substrate to be processed.
[18] A patterning process for forming a pattern in a substrate to be processed, comprising the steps of:
   (II-1) applying the composition for forming a resist underlayer film according to any one of [1] to [16] onto a substrate to be processed to obtain a coating film, then heating the coating film to form a resist underlayer film;
   (II-2) forming a resist middle layer film on the resist underlayer film;
   (II-3) forming a resist upper layer film on the resist middle layer film by using a photoresist material;
   (II-4) subjecting the resist upper layer film to pattern exposure and then to development with a developer to form a pattern in the resist upper layer film;
   (II-5) transferring the pattern to the resist middle layer film by dry etching while using the resist upper layer film having the formed pattern as a mask;
   (II-6) transferring the pattern to the resist underlayer film by dry etching while using the resist middle layer film having the transferred pattern as a mask; and
   (II-7) processing the substrate to be processed while using the resist underlayer film having the formed pattern as a mask to form the pattern in the substrate to be processed.
[19] A patterning process for forming a pattern in a substrate to be processed, comprising the steps of:
   (III-1) applying the composition for forming a resist underlayer film according to any one of [1] to [16] onto a substrate to be processed to obtain a coating film, then heating the coating film to form a resist underlayer film;
   (III-2) forming an inorganic hard mask middle layer film selected from a silicon oxide film, a silicon nitride film, and a silicon oxynitride film on the resist underlayer film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then to development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the resist underlayer film by dry etching while using the inorganic hard mask middle layer film having the transferred pattern as a mask; and
   (III-8) processing the substrate to be processed while using the resist underlayer film having the formed pattern as a mask to form the pattern in the substrate to be processed.
[20] The patterning process according to any one of [17] to [19], wherein a substrate having a structure or step having a height of 30 nm or more is used as the substrate to be processed.
[21] A method for forming a resist underlayer film that serves as an organic flat film used in a semiconductor device manufacturing process, the method comprising:
   applying the composition for forming a resist underlayer film according to any one of [1] to [16] onto a substrate to be processed by spin-coating to obtain a coating film; and
   heating the coating film at a temperature of 450°C or higher and 800°C or lower for 10 to 600 seconds to cure the coating film and form a resist underlayer film.
[22] A method for forming a resist underlayer film that serves as an organic flat film used in a semiconductor device manufacturing process, the method comprising:
   applying the composition for forming a resist underlayer film according to any one of [1] to [16] onto a substrate to be processed by spin-coating to obtain a coating film; and
   heating the coating film under an atmosphere with an oxygen concentration of 1% or more and 21% or less to cure the coating film and form a resist underlayer film.
[23] A method for forming a resist underlayer film that serves as an organic flat film used in a semiconductor device manufacturing process, the method comprising:
   applying the composition for forming a resist underlayer film according to any one of [1] to [16] onto a substrate to be processed by spin-coating to obtain a coating film; and
   heating the coating film under an atmosphere with an oxygen concentration of less than 1% to cure the coating film and form a resist underlayer film.
[24] The method for forming a resist underlayer film according to any one of [21] to [23], wherein a substrate having a structure or step having a height of 30 nm or more is used as the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a resist underlayer film, comprising:
(A) a polymer having a structure represented by the following general formula (1) as a repeating unit; and
(B) an organic solvent,
wherein the polymer (A) has a molecular weight of 300 to 3,000, and the polymer (A) contains neither a repeating unit containing a hydroxy group as a substituent nor a repeating unit containing a heteroaromatic ring, 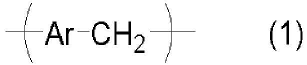 wherein Ar represents an unsubstituted divalent aromatic group having 6 to 30 carbon atoms.

2. The composition for forming a resist underlayer film according to claim 1, wherein the aromatic group Ar has any of the following structures (1-a), 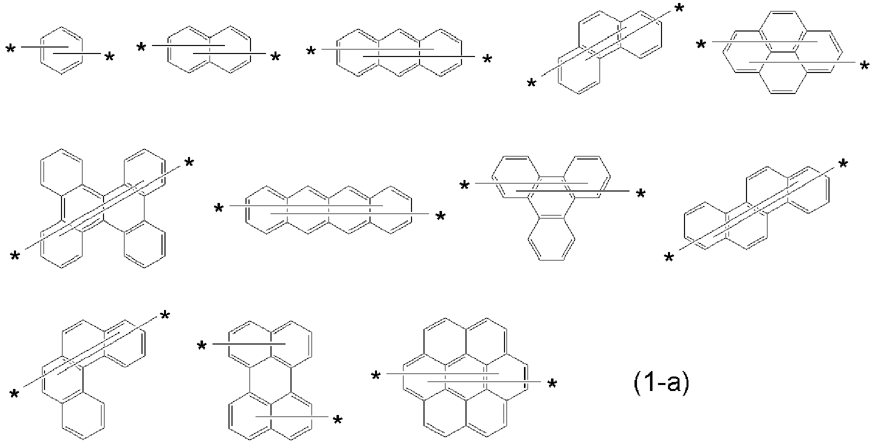 wherein "*" represents an attachment point to the methylene group in the general formula (1).

3. The composition for forming a resist underlayer film according to claim 1 or 2, wherein the aromatic group Ar represents any of naphthalene, anthracene, phenanthrene, and pyrene.

4. The composition for forming a resist underlayer film according to any one of claims 1 to 3, wherein the polymer (A) is a copolymer having two kinds of repeating units represented by the following general formulae (2), 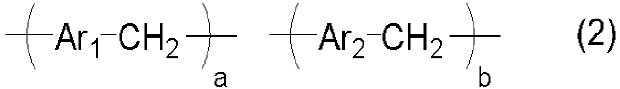 wherein Ar₁ represents any of naphthalene, anthracene, phenanthrene, and pyrene; Ar₂ has a structure different from that of Ar₁ and has any structure selected from the following formulae (1-a); and a+b is 100, 30 ≤ a ≤ 99, and 1 ≤ b ≤ 70, 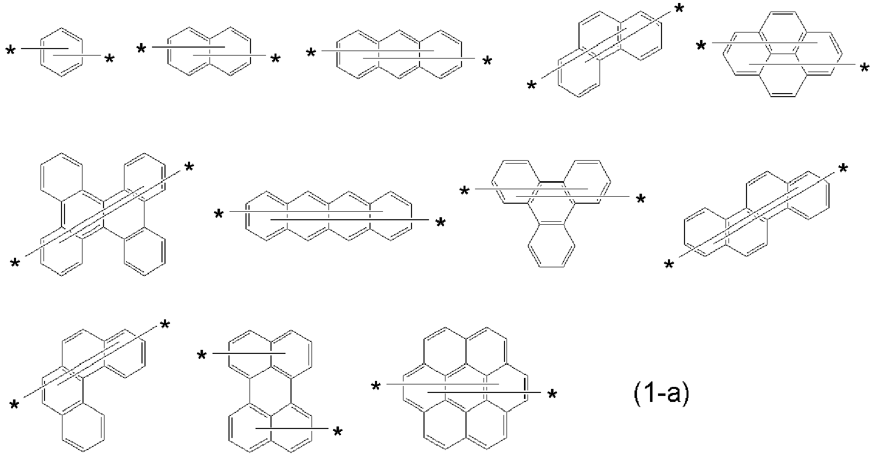 preferably wherein the polymer (A), being the copolymer having two kinds of repeating units represented by the general formulae (2), is a polymerization reaction product of a monomer represented by the following formula (2-a) and a monomer represented by the following formula (2-b),
**Ar₁-CH₂-X** **(2-a)**
**Ar₂-CH₂-X** **(2-b)**
wherein Ar₁ represents any of naphthalene, anthracene, phenanthrene, and pyrene; Ar₂ has a structure different from that of Ar₁ and has any structure selected from the formulae (1-a); and X represents a hydroxy group, an alkoxy group having 1 to 4 carbon atoms, or a halogen group, and more preferably wherein the Ar₁ in the formulae (2) is anthracene.

5. The composition for forming a resist underlayer film according to any one of claims 1 to 4, wherein the polymer (A) has a molecular weight of 300 to 1,500.

6. The composition for forming a resist underlayer film according to any one of claims 1 to 5, wherein the polymer (A) has an end-capping group represented by the following general formula (3), 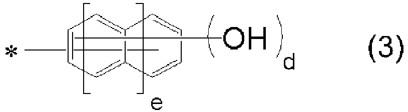 wherein "*" represents an attachment point to the methylene group in the formula (1); "d" represents an integer of 1 to 9; and "e" represents an integer of 0 to 2 .

7. The composition for forming a resist underlayer film according to any one of claims 1 to 6, further comprising (C) a blend resin, being a phenolic resin or a resin containing a phenolic hydroxy group,
preferably wherein the blend resin (C) has a molecular weight of 4,000 to 12,000, and
more preferably wherein the blend resin (C) is contained in an amount of 10 to 100 parts by mass based on 100 parts by mass of the polymer (A).

8. The composition for forming a resist underlayer film according to claim 7, wherein the blend resin (C) is a resin represented by any of the following general formulae (C-1), (C-2), and (C-3), 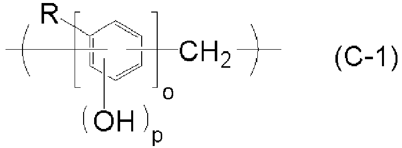 wherein R represents an organic group having a valency of 1 to 3, having 1 to 20 carbon atoms, and optionally containing an oxygen atom; "o" represents an integer of 1 to 3; and "p" represents an integer of 1 to 3, 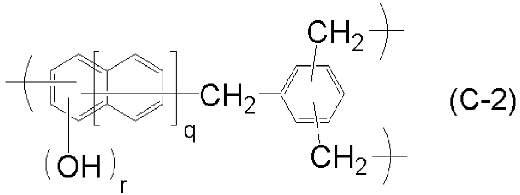 wherein "q" represents an integer of 0 or 1; and "r" represents an integer of 1 to 6, 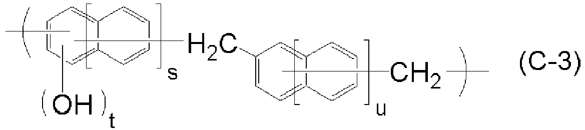 wherein "s" represents an integer of 0 or 1; "t" represents an integer of 1 to 6; and "u" represents an integer of 0 or 1.

9. The composition for forming a resist underlayer film according to any one of claims 1 to 8, further comprising (D) a crosslinking agent having a structure represented by the following general formula (4), 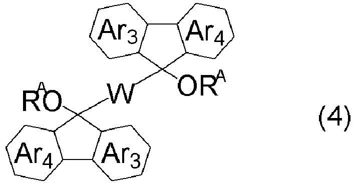 wherein Ar₃ and Ar₄ each represent a benzene ring or naphthalene ring optionally having a substituent; R^{A} represents a hydrogen atom or a monovalent organic group having 1 to 20 carbon atoms; W represents a group represented by any of the following general formulae (5), 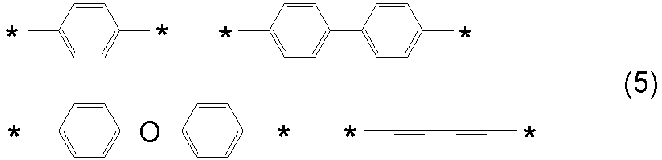 wherein "*" represents an attachment point.

10. The composition for forming a resist underlayer film according to any one of claims 1 to 9, further comprising (E) a flowability accelerator having a weight reduction rate of less than 30% on heating from 30°C to 190°C and having a weight reduction rate of 98% or more on heating from 30°C to 350°C, and
preferably wherein the flowability accelerator (E) contains one or more compounds selected from the group consisting of compounds represented by the following general formulae (i) to (iii), 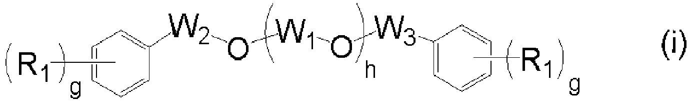 wherein each R₁ independently represents a hydrogen atom, a hydroxy group, or an organic group having 1 to 10 carbon atoms and optionally being substituted; W₁ represents a phenylene group or a divalent group represented by the following general formula (i-1); W₂ and W₃ each represent a single bond or a divalent group represented by either of the following general formulae (i-2); "g" represents an integer of 1 to 5; and "h" represents an integer of 0 to 10, 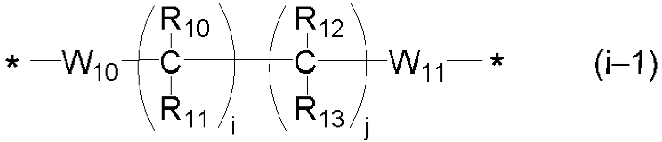 wherein "*" represents an attachment point; R₁₀, R₁₁, R₁₂, and R₁₃ each represent a hydrogen atom, a hydroxy group, or an organic group having 1 to 10 carbon atoms; W₁₀ and W₁₁ each independently represent a single bond or a carbonyl group; and "i" and "j" each represent an integer of 0 to 10, provided that i + j ≥ 1, 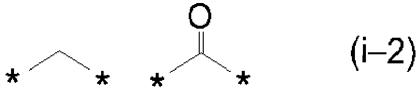 wherein "*" represents an attachment point, 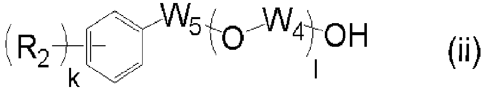 wherein each R₂ independently represents a hydrogen atom or an organic group having 1 to 10 carbon atoms and optionally being substituted; W₄ represents a divalent group represented by the following general formula (ii-1); W₅ represents a single bond or a divalent group represented by either of the following general formulae (ii-2); "k" represents an integer of 0 to 5; and "l" represents an integer of 2 to 10, 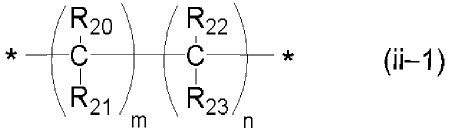 wherein "*" represents an attachment point; R₂₀, R₂₁, R₂₂, and R₂₃ each represent a hydrogen atom, a hydroxy group, or an organic group having 1 to 10 carbon atoms; and "m" and "n" each represent an integer of 0 to 10, provided that m + n ≥ 1, 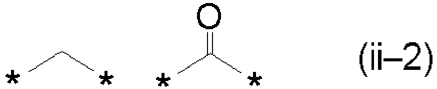 wherein "*" represents an attachment point, 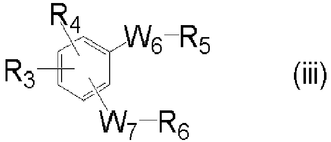 wherein R₃ and R₄ each represent a hydrogen atom, a hydroxy group, or an organic group having 1 to 10 carbon atoms, optionally being substituted, and optionally being bonded to each other to form a cyclic structure; R₅ and R₆ each represent an organic group having 1 to 10 carbon atoms, R₅ being a group containing either an aromatic ring or a divalent group represented by the following general formula (iii-1); and W₆ and W₇ each represent a single bond or a divalent group represented by either of the following general formulae (iii-2), at least one of W₆ and W₇ being a divalent group represented by either of the general formulae (iii-2), 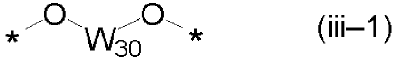 wherein "*" represents an attachment point; and W₃₀ represents an organic group having 1 to 4 carbon atoms, 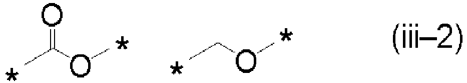 wherein "*" represents an attachment point.

11. The composition for forming a resist underlayer film according to any one of claims 1 to 10, further comprising one or more of:
(F) a surfactant;
(G) an acid generator; and
(H) a plasticizer.

12. A patterning process for forming a pattern in a substrate to be processed, comprising the steps of:
(I-1) applying the composition for forming a resist underlayer film according to any one of claims 1 to 11 onto a substrate to be processed to obtain a coating film, then heating the coating film to form a resist underlayer film;
(I-2) forming a resist upper layer film on the resist underlayer film by using a photoresist material;
(I-3) subjecting the resist upper layer film to pattern exposure and then to development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed, or
a patterning process for forming a pattern in a substrate to be processed, comprising the steps of:
(II-1) applying the composition for forming a resist underlayer film according to any one of claims 1 to 11 onto a substrate to be processed to obtain a coating film, then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then to development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed, or
a patterning process for forming a pattern in a substrate to be processed, comprising the steps of:
(III-1) applying the composition for forming a resist underlayer film according to any one of claims 1 to 11 onto a substrate to be processed to obtain a coating film, then heating the coating film to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

13. The patterning process according to claim 12, wherein a substrate having a structure or step having a height of 30 nm or more is used as the substrate to be processed.

14. A method for forming a resist underlayer film that serves as an organic flat film used in a semiconductor device manufacturing process, the method comprising:
applying the composition for forming a resist underlayer film according to any one of claims 1 to 11 onto a substrate to be processed by spin-coating to obtain a coating film; and
heating the coating film at a temperature of 450°C or higher and 800°C or lower for 10 to 600 seconds to cure the coating film and form a resist underlayer film, or
a method for forming a resist underlayer film that serves as an organic flat film used in a semiconductor device manufacturing process, the method comprising:
applying the composition for forming a resist underlayer film according to any one of claims 1 to 11 onto a substrate to be processed by spin-coating to obtain a coating film; and
heating the coating film under an atmosphere with an oxygen concentration of 1% or more and 21% or less to cure the coating film and form a resist underlayer film, or
a method for forming a resist underlayer film that serves as an organic flat film used in a semiconductor device manufacturing process, the method comprising:
applying the composition for forming a resist underlayer film according to any one of claims 1 to 11 onto a substrate to be processed by spin-coating to obtain a coating film; and
heating the coating film under an atmosphere with an oxygen concentration of less than 1% to cure the coating film and form a resist underlayer film.

15. The method for forming a resist underlayer film according to claim 14, wherein a substrate having a structure or step having a height of 30 nm or more is used as the substrate to be processed.
